# EUROPEAN PATENT APPLICATION

(11) **EP 1 063 247 A1**
(43) Date of publication of application: **27.12.2000**
(21) Application number: 99961345.8
(22) Date of filing: 24.12.1999
(51) Int. Cl.: C08F 299/02, C08F 290/12, C08F 8/14, C08F 2/50, C08G 59/42, C08L 63/00, G03F 7/027, G02B 5/20, H04N 5/66, H05K 3/06, H05K 3/28, C09D 133/06

(54) **CURABLE RESIN COMPOSITION, MODIFIED COPOLYMER AND RESIN COMPOSITION, AND ALKALI DEVELOPMENT TYPE PHOTOCURABLE GLASS PASTE**

(30) Priority: 28.12.1998 JP 37207598; 08.03.1999 JP 6009999; 05.04.1999 JP 9738899; 11.05.1999 JP 12948499
(71) Applicant: DAICEL CHEMICAL INDUSTRIES, Ltd., Sakai-shi, Osaka 590-0905 (JP)
(72) Inventor: MIYAKE, Hiroto, Ohtake-shi, Hiroshima 739-0651 (JP); MARUO, Katsuya, Ohtake-shi, Hiroshima 739-0651 (JP)
(74) Representative: Portal, Gérard
(86) International application number: JP9907249
(87) International publication number: WO0040632

(57) **Abstract**

There are provided a curable resin composition having an excellent resist layer formability and ink sensitivity which comprises using a modified copolymer in which an epoxy group-contained unsaturated compound is added to a portion of acid groups in a copolymer primarily containing acrylic acid and a (meth)acrylate as a main comonomer component, a photo and heat curable resin comprising a modified copolymer in which there is employed a specified copolymer having Tg of not less than 50°C, which has an excellent ink sensitivity and a tackfree property, and a composition therefrom, a curable resin composition for a resist having improved various properties to be required, an excellent sensitivity, resolution, and plating resistance which comprises addition or copolymerization of an acrylate monomer having a functional group such as acryloyl morpholine to a copolymer in which β-carboxyethylacrylate is partially employed after or before epoxy modification, and an alkali-developable type photocurable glass paste composition which comprises containing a curable resin, a photopolymerization initiator, a photopolymerizable monomer, a solvent for dilution, and glass frit, in which there can be formed a fine-grained cell barriers pattern on a base plate for a large-sized plasma display panel with a high yield and stable and excellent productivity while keeping good working circumstances.

## Description

### TECHNICAL FIELD

The present invention relates to a curable resin and a curable resin composition and, particularly, it relates to a resin composition having a photo- and/or heat-curability. Specifically, since it can provide a photo- or heat-sensitive resin composition in which a picture image is capable of being formed through photo-exposing and developing by a diluted aqueous alkali solution after formation of a coating thin layer using the curable resin composition, it is preferred for a print circuit board, an LSI-related article, a color filter using a liquid crystal, a protecting layer, and a prism sheet, etc., which relate to electronics, and a binder resin for a resist ink such as an encapsulating agent, etc.

Further, the present invention relates to a photo- or heat-curable modified copolymer or resin composition.

In more detail, it relates to a modified copolymer or a resin composition in which there are employed β-carboxyethylacrylate, an acid group-contained unsaturated compound, a (meth)acrylate, a functional group-contained acrylate monomer, a modified copolymer in which an epoxy group-contained unsaturated compound which can react with above compounds is a raw material for the preparation or a resin composition.

Thin layer in which the modified copolymer or the resin composition is employed can be developed by an aqueous alkali solution after forming a pattern, and it is utilized as a print circuit board, an LSI, a color filter using a liquid crystal, and a binder resin for a resist ink such as an encapsulating agent, etc.

Still further, the present invention relates to an alkali-developable type photo-curable glass paste composition for forming cell barriers in a plasma display panel (PDP) and a method for the preparation of the cell barriers in a plasma display panel using thereof.

### BACKGROUND ART

In recent years, a development by solvents is shifting to a development by a diluted aqueous alkali solution in various fields because of an environmental problem, resource saving, energy saving, and improvement of workability, etc, and, even in a field for fabricating a print circuit board, a resist ink is shifting from the development by solvents to the development by a diluted aqueous alkali solution by the same reason.

On the other hand, in the print circuit board, a solder resist is widely employed as a permanently-protecting thin layer for a circuit board. Thin layer of a solder resist resin is formed over all the surface except conductive portions in the circuit board to be soldered, and a main function thereof is to prevent oxidation and corrosion of circuit conductors together with preventing adherence of a solder to unnecessary portions when electronic parts are soldered in a print circuit board.

For that reason, a solder resist before curing requires coatability, photo-sensitivity or heat sensitivity, solubility to an aqueous alkali solution, etc., and a resin after curing requires adhesion, solder resistance, plating resistance, and an electric insulation property, etc.

Heretofore, in the case of forming a solder resist thin layer on a print circuit board, a heat-curable type resist ink is printed by a screen printing method, and then, a printed portion was cured by heating or an ultraviolet ray. However, in the screen printing method, there were caused phenomena such as bleeding, blotting, and running in printing, resulting in becoming incapable of responding to a recent shift to high integration in a circuit board. In order to solve the problem, a photographic method such as a microphotographic exposure has been developed.

The photographic method is a method in which a desired pattern is formed by developing after exposure through a film having a pattern.

Heretofore, although organic solvents have been employed in development of a photosolder resist ink, the tendency is being toward a type being capable of developing using a diluted aqueous solution from a viewpoint of an environmental pollution. As such the resist ink, as described in JP-B-89054390 Official Gazette, etc., there is essentially employed a compound which is obtained by addition of a polybasic acid anhydride to a reaction product of a novolak type epoxy compound with an unsaturated monocarboxylic acid. However, although a solder resist ink obtained by the compound is excellent in heat resistance, there is remained a problem that tackiness is apt to be revealed because of a low sensitivity in the ink and a broad molecular weight distribution.

Further, in JP-A-63011930 and JP-A-63020564 Official Gazettes, although there is proposed a composition using a half-ester compound of a copolymer of styrene with maleic anhydride, since the compound has a benzene ring structure, an ink using the composition has (1) a drawback that it absorbs an ultraviolet ray, resulting in lowering sensitivity of an ink, and (2) a drawback that an electric property becomes worse.

In order to solve the above-described drawbacks, there is proposed a resin composition in which a cycloaliphatic epoxy group-contained unsaturated compound is added to a poly(meth)acrylic resin in JP-A-01289820 and JP-A-06138659 Official Gazettes.

However, it is not still sufficient from a viewpoint of the sensitivity as described above.

Further, in the ink using the composition, tackiness, that is, an adhering property occasionally remains when pre-drying for removing solvents, and conditions in pre-drying are strengthened in order to completely eliminate the tackiness for the purpose of preventing spots in a negative film. In general, since developability after exposure becomes worse by curing of the ink through heating, a heating period of time is extended instead of elevation of temperature. For that reason, a pre-drying period of time becomes a bottle neck in a manufacturing process of a print circuit board, resulting in becoming an obstacle for an effective production.

In order to solve the above-described problem, there is proposed a resin composition in JP-A-01289820 and JP-A-06138659 Official Gazettes in which an unsaturated compound having a cycloaliphatic epoxy group is added to a poly(meth)acrylic resin.

However, it is not still sufficient from a viewpoint of the sensitivity against an ultraviolet ray, etc.

Further, there are remained a problem that a coating thin layer is peeled (referred to a plating resistance) in severe treating conditions such as a chemical gold-plating, and a problem such as resolution, etc.

Plasma-display panel (PDP) is a flat display in which a fluorescent material is coated over an inner bottom surface in many cells formed by separating through two glass plates at a front surface and back surface and a glass-made cell barrier (a barrier rib), and it is emitted by gas-discharge, whereby, there are displayed a projected image and an information, and it is classified into a DC type and an AC type according to a panel structure and a driving method.

In the DC-type PDP, spaces in respective cells are separated by a lattice-shape cell barrier and, on the other hand, in the AC-type PDP, spaces in respective cells are separated by a U-shape tubular cell barrier. In the both type PDP, spacing of cells is separated by cell barriers.

The cell barriers have a function that a luminescent discharge is limited within a fixed range as being excellently displayed without causing an error discharge and cross-talk between cells discharged, and a function for elevating a mechanical strength in the whole of a panel while maintaining a uniform discharge space by height, width, and a pattern gap.

For that reason, it is required that a space for discharging a gas is designed as broadly as possible and the cell barriers are designed as thinly as possible in order to obtain a high luminance in the plasma display panel.

That is, it is required that there are formed narrow and high cell barriers having a large height/width ratio (aspect ratio) and a sufficient strength.

Heretofore, the cell barriers in the plasma display panel have been usually formed as glass-made cell barriers by burning organic substances by calcination after patterning a photocurable resin paste, etc. containing glass frit using a screen printing method.

In the case that the patterning is performed using the screen printing method, it is required that a plurality of prints (multiple coating) are separately performed because of a thick coating layer. In the multiple coating, it is very difficult to adjust a screen slackening and pressure control in a squeegee, a proportion defective of the cell barriers increases by generation of dislocation. Further, in a shift of to a large-sized picture scope and a shift to a high precision and fine pattern which are required in the plasma display panel, there has been a problem that skillfulness is required in the case of a conventional screen printing method and, further, a problem such as blur and blot in printing, and accuracy of positioning caused by expansion and contraction in a screen, resulting in that a proportion defective of the cell barriers increases.

Therefore, as a method for forming cell barriers which can be employed in place of the screen printing method, a photolithography method is proposed (for example, refer to JP-A-02165538). Further, there is also proposed a method in which a black-colored pigment is added in order to prevent a halation in curing by an ultraviolet ray (for example, refer to JP-A-06144871).

In the photolithography method, a pattern for the cell barriers is formed by coating an ultraviolet ray-curable glass paste material onto a glass base plate, and by exposing to light and developing.

However, a conventionally-known one is an organic solvent-developing type one, and a large amount of a developer is required for removal (that is, developing) of uncured portions after photocuring, and working circumstances become worse, and it becomes problematic in profitability. For that reason, there has been desired a development of a nonsolvent-developing type one, and there is proposed an ultraviolet ray-curable glass paste material which can be developed in an aqueous alkali solution state.

As a method for forming cell barriers which is capable of developing in the aqueous alkali solution state, there is a method described in JP-A-10072240. In the method, there is employed a resin in which glycidyl(meth)acrylate is introduced into an acrylic resin having acid groups by an addition reaction.

However, since glycidyl(meth)acrylate alone can be actually employed from a viewpoint of harmfulness in monomers, it becomes problematic from a viewpoint of low sensitivity and resolution.

Further, since a glass transition point Tg is low in the acrylic resin, a long time of period is required for a removal process of tackiness (attaining to a dried state in finger touching) before exposing to light, and there has been a problem that deformation of a pattern is caused in calcination which is a final process.

In the meantime, in order to modify an ultraviolet ray-curable type resin composition to an alkali-developable type one which is a useful means from a viewpoint of protection of working circumstances, it has been generally known that a polymeric compound having carboxylic groups is employed as an ultraviolet ray-curable resin.

However, in the case that the polymeric compound having carboxylic groups is formulated in a glass paste composition which is employed for forming cell barriers in the plasma display panel, viscosity stability is remarkably worse in a paste obtained, and it is not suitable for practical uses.

That is, in the case that the viscosity stability is worse in the glass paste composition, it becomes difficult to stably form a constant cell barrier pattern having a large height/width ratio, and it becomes largely problematic from a viewpoint of performance in the plasma display panel.

Further, there is also a problem that workability becomes worse by gelation of the composition and a decline of flowability.

Accordingly, a purpose of No. I in the present invention is to provide a curable resin composition which is excellent in formability of a resist thin layer and sensitivity of an solder resist ink.

Further, a purpose of No. II in the present invention is to provide a photo- and/or heat-curable resin and a resin composition thereof which are excellent in an ink sensitivity and have a tackfree property (adhesion resistance).

Still further, a purpose of No. III in the present invention is to provide a curable material for a solder resist which satisfies a variety of properties to be required in solder resist, which is high in sensitivity and excellent in resolution, and which has an improved plating resistance.

Also, a purpose of No. IV in the present invention is to provide an alkali-developable type photo-curable glass paste composition for a plasma display panel which can readily form a constant and fine-grained cell barrier pattern having a large-sized picture scope with an excellent yield by a photo-lithography technology, and which does not include the above-described problems as shown in a conventional glass paste composition. And also, the present invention is to provide a method for the preparation of cell barriers in a plasma display panel, by which a pattern of a fine-grained cell barriers can be economically formed onto a base plate for a plasma display panel having a large-sized picture scope with an excellent productivity by a photo-lithography technology without a change for the worse in working circumstances.

### DISCLOSURE OF THE INVENTION

I. The present Inventor, as a result of an intensive investigation for solving the above-described purpose of the No. I, has found out that a curable resin composition using a modified copolymer is a photo- or heat-curable resin composition which is soluble to a diluted aqueous alkali solution and, in which heat- or photo-sensitivity is jumpingly elevated and heat resistance is simultaneously elevated by introducing a monomer unit based on acrylic acid into the copolymer structure, and the present invention was completed. In the modified copolymer, monomer units based on an acrylate and a (meth)acrylate are employed as a main constructing component and an epoxy group-contained unsaturated compound is added to partial acid groups thereof.
That is, No. 1 of the present invention provides a curable resin composition which comprises using a modified copolymer in which an epoxy group-contained unsaturated compound is added to partial acid groups in a copolymer containing acrylic acid and a (meth)acrylate as a main comonomer component.
Further, No. 2 of the present invention provides a curable resin composition of the No. 1 in the present invention, in which there is employed a compound except acrylic acid having an unsaturated group and at least one acid group in place of a portion of the acrylic acid.
No. 3 of the present invention provides a curable resin composition of the No. 1 or the No. 2 in the present invention, in which the epoxy group-contained unsaturated compound is a cycloaliphatic epoxy group-contained unsaturated compound.
No. 4 of the present invention provides a curable resin composition of the No. 3 in the present invention, in which the epoxy group-contained unsaturated compound is particularly 3,4-epoxycyclohexylmethyl(meth)acrylate.
Further, No. 5 of the present invention provides a curable resin composition of any one of the Nos. 1-4 in the present invention, in which the curable resin composition contains a photo-polymerization initiator and a monomer or oligomer for dilution together with the epoxy group-contained unsaturated compound.
Still further, No. 6 of the present invention provides a curable resin composition of any one of the Nos. 1-5 in the present invention, in which an epoxy compound and/or an epoxy resin are contained. No. 7 in the present invention provides a curable resin composition of any one of the Nos. 1-6 in the present invention, in which pigments are contained in addition to those.
Besides, No. 8 and No. 9 in the present invention provide a curable resin composition of any one of the Nos. 1-7 in the present invention, which is employed as photocurable components or heat curable components for a liquid resist, a dry film, and a pigment resist for a color filter.
   II. The present inventors have found out that a curable resin composition can solve the purpose of the No. II in the present invention, which comprises a modified copolymer obtained by addition of an epoxy group-contained unsaturated compound to a portion of acid groups in a copolymer having a specified Tg (a glass transition temperature) obtained from a compound (AII) having a divalent group which can be bonded between an unsaturated group and carboxylic group and, a (meth)acrylic acid and a (meth)acrylate, and the present invention was completed.
That is, No. 10 in the present invention provides a curable resin composition comprising a modified copolymer obtained by addition of an epoxy group-contained unsaturated compound (CII) to a portion of acid groups in a copolymer (BII) having a Tg (a glass transition temperature) of not less than 50°C obtained from a compound (AII) having a divalent group which can be bonded between an unsaturated group and carboxylic group and, a (meth)acrylic acid and a (meth)acrylate.
No. 11 in the present invention provides a curable resin composition of the No. 10 in the present invention, in which the compound (AII) having a divalent group which can be bonded between an unsaturated group and carboxylic group is β-carboxyethyl (meth)acrylate.
No. 12 in the present invention provides a curable resin composition of the No. 10 or No. 11 in the present invention, in which the epoxy group-contained unsaturated compound (CII) is 3,4-epoxycyclohexylmethyl(meth)acrylate.
No. 13 in the present invention provides a curable resin composition which comprises the curable resin of the No. 12 in the present invention and a monomer or oligomer for dilution, and which is soluble to a diluted aqueous alkali solution.
Further, No. 14 in the present invention provides a curable resin composition which comprises the curable resin of the No. 12 in the present invention, a photo-polymerization initiator, and a monomer or oligomer for dilution, and which is soluble to a diluted aqueous alkali solution.
No. 15 in the present invention provides a curable resin composition in which the respective curable resin composition of the No. 13 or 14 in the present invention further contains an epoxy compound and/or an epoxy resin.
No. 16 of the present invention provides a curable resin composition of any one of the Nos. 13-15 in the present invention which further contains pigments.
Further, No. 17 in the present invention provides a curable resin composition of any one of the Nos. 13-16 in the present invention which contains a resin in which an acid anhydride is added after modifying a novolak or bisphenol-based epoxy resin with a (meth)acrylic acid.
Still further, No. 18 in the present invention provides a curable resin composition of any one of the No. 13 or 14 in the present invention which is employed as a liquid resist, a dry film, a color filter for a liquid crystal display, a pigment resist for black matrix, and a protecting layer for a coating.
   III. The present inventors, as a result of an intensive investigation for attaining the purpose of No. III in the present invention, have found out that the above-described problems can be solved by the use of a resin composition in which an acrylate monomer having functional groups such as acetoacetoxyethyl acrylate, acryloyl morpholine, and tetrahydrofurfuryl acrylate is added to a modified copolymer obtained by addition of an epoxy group-contained unsaturated compound to a portion of acid groups in a copolymer composed of β-carboxyethyl(meth)acrylate, a (meth)acrylic acid, and a (meth)acrylate, or the use of a modified copolymer obtained by addition of the epoxy group-contained unsaturated compound to a portion of acid groups in a copolymer in which the acrylate monomer having functional groups is introduced into the copolymer structure, and the present invention was completed.
That is, No. 19 in the present invention provides a resin composition comprising adding at least one of an acrylate monomer (eIII) having functional groups selected from acetoacetoxyethyl acrylate, acryloyl morpholine, and tetrahydrofurfuryl acrylate to a modified copolymer (BIII) obtained by addition of an epoxy group in an epoxy group-contained unsaturated compound (dIII) to a portion of acid groups in a copolymer (PIII-2) composed of β-carboxyethyl(meth)acrylate (aIII), an unsaturated compound having an acid group, and a (meth)acrylate (cIII).
No. 20 in the present invention provides a modified copolymer obtained by addition of an epoxy group in an epoxy group-contained unsaturated compound (dIII) to a portion of acid groups in a copolymer (PIII-1) composed of β-carboxyethyl(meth)acrylate (aIII), an unsaturated compound (bIII) having an acid group, and a (meth)acrylate (cIII), at least one of an acrylate monomer (eIII) having functional groups selected from acetoacetoxyethyl acrylate, acryloyl morpholine, and tetrahydrofurfuryl acrylate.
No. 21 in the present invention provides a resin composition of the No. 19 in the present invention, characterized in that the epoxy group-contained unsaturated compound (dIII) is 3,4-epoxycyclohexylmethyl(meth)acrylate.
No. 22 in the present invention provides a modified copolymer of the No. 20 in the present invention, characterized in that the epoxy group-contained unsaturated compound (dIII) is 3,4-epoxycyclohexylmethyl(meth)acrylate.
No. 23 in the present invention provides a resin composition which comprises a resin composition of No. 19 in the present invention and/or a modified copolymer of the No. 20 in the present invention, and other epoxy compounds (DIII).
No. 24 in the present invention provides a resin composition which comprises a resin composition of No. 19 or 23 in the present invention or a modified copolymer of the No. 20 in the present invention, and other compounds (EIII) having an unsaturated group and an acid group obtained by addition of an acid anhydride after modifying a novolak-based epoxy resin and/or a bisphenol-based epoxy resin by a (meth)acrylic acid.
   By the No. III in the present invention, there is provided a modified copolymer or a resin composition in which sensitivity is high, resolution is excellent, a plating resistance is improved, and finger touch dryability is excellent as a curing material for a solder resist.
   IV. The present inventors, as a result of an intensive investigation for attaining the purpose of No. IV in the present invention, have found out that there can be prepared a glass cell barrier having a high sensitivity, a high resolution, and a high accuracy, and which is soluble to an aqueous alkali solution by the use of a copolymer resin in which a cycloaliphatic unsaturated compound having an epoxy group is allowed to react with an acrylic-based resin having acid groups, and which is formulated in a glass paste, and the present invention was completed.
That is, No. 25 in the present invention provides an alkali-developable type photo-curable glass paste composition characterized by containing the (AIV), (BIV), (CIV), (DIV), and (EIV) described below.
   (AIV): a copolymeric resin in which an unsaturated compound (dIV) having an cycloaliphatic epoxy group is allowed to react to a portion of acid groups in a copolymer (cIV) obtained from a (meth)acrylate (aIV) and a compound (bIV) having an unsaturated group and at least one acid groups.
   (BIV): a photopolymerization initiator
   (CIV): a photopolymerizable monomer
   (DIV): a solvent for dilution
   (EIV): a glass frit
No. 26 in the present invention provides an alkali-developable type photo-curable glass paste composition of the No. 25 in the present invention, characterized by further containing a phosphoric acid compound (FIV) and ceramic powder (GIV).
No. 27 of the present invention provides an alkali-developable type photo-curable glass paste composition of the No. 25 or 26 in the present invention, characterized by further containing a black-colored pigment (HIV).
No. 28 in the present invention provides an alkali-developable type photo-curable glass paste composition of the No. 25 in the present invention, characterized in that a weight average molecular weight is 5,000-50,000, an acid value is 50-150 KOH mg/g, and a double bond equivalent is 400-2,000 in the copolymeric resin (AIV).
No. 29 in the present invention provides an alkali-developable type photo-curable glass paste composition of the No. 28 in the present invention, characterized by using a mixture of a copolymeric resin (AIV) having an acid value of not less than 100 KOH mg/g with a copolymeric resin (AIV) having an acid value of less than 100 KOH mg/g.
No. 30 in the present invention provides an alkali-developable type photo-curable glass paste composition of the No. 28 in the present invention, in which a glass transition point is 300-550°C in the glass frit.
No. 31 in the present invention provides an alkali-developable type photo-curable glass paste composition of the No. 27 in the present invention, in which the black-colored pigment (HIV) is a metal oxide pigment primarily containing at least one or more of an oxide of Fe, Cr, Mn, and Co, and which contains 3-100 parts by weight of the metal oxide pigment based on 100 parts by weight of the glass frit (EIV).
No. 32 in the present invention provides a method for the preparation of cell barriers in a plasma display panel, characterized by including a step for coating an alkali-developable type photo-curable glass paste composition of any one of the Nos. 25-31 in the present invention onto a glass base plate for a plasma display panel to prepare a coating layer, a step for selectively exposing the coating layer to an active beam depending upon a fixed pattern, a step for removing unexposed portions in the coating layer by developing using an aqueous alkali solution, and a step for calcining the coating layer after developing.

### BEST MODE FOR CARRYING OUT THE INVENTION

Hereinafter, the present inventions are illustrated in detail.

I. First of all, the No. I of the present invention is illustrated.

The modified copolymer to be employed for the curable resin composition in the present invention is a modified copolymer in which a copolymer obtained from comonomers such as acrylic acid and a (meth)acrylate is modified by a specified compound having a reactivity and, as an embodiment thereof, a portion of the acrylic acid can be replaced with a compound having an unsaturated group and at least one acid groups except acrylic acid. Accordingly, acrylic acid essentially exists in a modified copolymer obtained by modification in both cases.

Herein, the reason why it is replaced with the compound except acrylic acid is as follows. So long as intending to replace with a compound which generally includes acrylic acid, acrylic acid which is identical to the compound must be excluded.

As the (meth)acrylate which is one of primary comonomer components, there are enumerated an alkyl(meth)acrylate such as methyl(meth)acrylate, ethyl(meth)acrylate, propyl(meth)acrylate, butyl(meth)acrylate, pentyl(meth)acrylate, and hexyl(meth)acrylate; a (meth)acrylate having hydroxyl group such as 2-hydroxyethyl(meth)acrylate, hydroxypropyl (meth)acrylate, and hydroxybutyl(meth)acrylate; a (meth)acrylate having hydroxyl group such as a caprolactone-modified 2-hydroxyethyl(meth)acrylate in which those are modified by a caprolactone; and an alkoxyalkylene glycol mono(meth)acrylate such as methoxydiethylene glycol(meth)acrylate, ethoxydiethylene glycol(meth)acrylate, isooctyloxydiethylene glycol(meth)acrylate, phenoxytriethylene glycol(meth)acrylate, methoxytriethylene glycol(meth)acrylate, and a methoxypolyethylene glycol(meth)acrylate, etc.

As the compound having an unsaturated group and at least one acid groups which is a compound employed by replacing with a portion of acrylic acid, there are enumerated methacrylic acid, vinylphenol, a modified unsaturated monocarboxylic acid in which a chain is extended between an unsaturated group and a carboxylic acid, for example, β-carboxyethyl(meth)acrylate, 2-acryloyloxyethyl succinic acid, 2-acryloyloxyethyl phthalic acid, 2-acryloyloxyethyl hexahydrophthalic acid, an unsaturated monocarboxylic acid having a lactone-modified ester bond, a modified unsaturated monocarboxylic acid having an ether bond, and an unsaturated dicarboxylic acid having at least two carboxylic groups such as maleic acid or an anhydride thereof, etc. These carboxylic acids, etc. may be employed solely or in combination.

As specific examples of the unsaturated monocarboxylic acid having a lactone-modified ester bond, there can be enumerated a lactone-modified compound of a (meth)acrylic acid represented by general formula (1) described below and a lactone-modified compound in which terminal hydroxyl group in a hydroxyalkyl(meth)acrylate (herein, there is shown an example that the alkyl is ethyl) is modified by an acid anhydride represented by general formula (2).

CH₂=C(R¹)CO[O(CR²R³)ₘCO]ₙOH (1)

CH₂=C(R¹)COOCH₂CH₂O- [CO(CR²R³)ₘO)ₙCOR⁴COOH (2)

(in the formulae, R¹ is a hydrogen atom or methyl group, m pieces of R² and R³ may be identical to or different from each other, and those are a hydrogen atom, methyl group, and ethyl group, R⁴ is a divalent saturated or unsaturated aliphatic hydrocarbon group having a carbon number of 1-10, a divalent saturated or unsaturated cycloaliphatic hydrocarbon group having a carbon number of 1-6, or a divalent aromatic hydrocarbon group such as p-xylilene group and phenylene group, m is an integer of 4-8, and n is an integer of 1-10, respectively).

Further, as specific examples of the modified unsaturated monocarboxylic acid having an ether bond, there can be enumerated an acid-modified product having an ether bond in which a terminal hydroxyl group is modified by an acid anhydride represented by general formula (3) described below.

CH₂=CR¹COO[-(CR⁵R⁶)ⱼO-]ₖ-COR⁴COOH (3)

(in the formulae, R¹ is a hydrogen atom or methyl group, j pieces of R⁵ and R⁶ may be identical to or different from each other, and those are a hydrogen atom, methyl group, and ethyl group, propyl group, or butyl group and, further, R⁴ is a divalent saturated or unsaturated aliphatic hydrocarbon group having a carbon number of 1-10, a divalent saturated or unsaturated cycloaliphatic hydrocarbon group having a carbon number of 1-6, or a divalent aromatic hydrocarbon group such as p-xylilene group and phenylene group, j and k are an integer of 1-10, respectively).

The acid anhydride may be even an acid anhydride having two or more carboxylic groups in the molecule such as maleic acid.

Further, the modified unsaturated monocarboxylic acid may be employed solely or in combination.

In the copolymer containing acrylic acid and a (meth)acrylate as main comonomers or the copolymer in which a portion of the acrylic acid is further replaced with a specified comonomer, an acid value preferably ranges in 50-700 mgKOH/g.

There is illustrated the copolymer containing acrylic acid and a (meth)acrylate as main comonomers or a modified copolymer in which an epoxy group-contained unsaturated compound is added to a portion of acid groups in the copolymer in which a portion of the acrylic acid is further replaced with a specified comonomer.

As the epoxy group-contained unsaturated compound, there is enumerated a compound having a radically polymerizable unsaturated group and an epoxy group in the molecule and, specifically, there is employed a compound having an unsaturated group and a cycloaliphatic epoxy group or an aliphatic epoxy group, and it is employed solely or in combination. Of the epoxy group-contained unsaturated compound, as specific examples of the former, there can be enumerated compounds represented by a variety of general formulae (4). 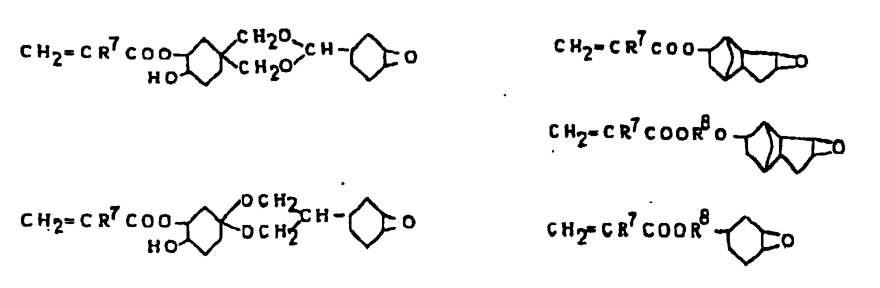 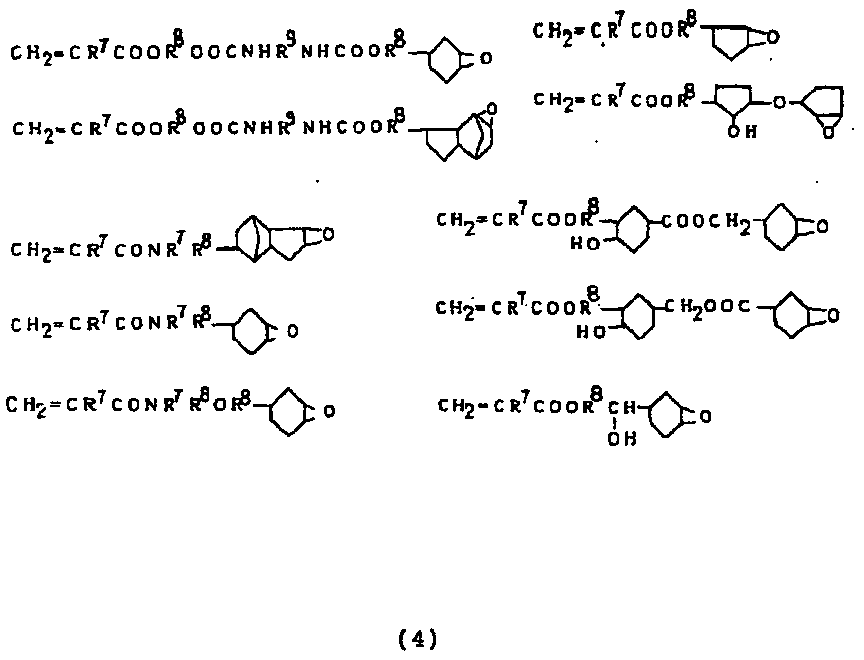 (in the formulae, R⁷ is a hydrogen atom or methyl group, R^{⁸} is a divalent aliphatic saturated hydrocarbon group having a carbon number of 1-6, and R⁹ is a divalent aliphatic hydrocarbon group having a carbon number of 1-10, respectively)

It is to be noted that 3,4-epoxycyclohexylmethyl (meth)acrylate is particularly preferred.

Further, as specific examples of the latter, there can be enumerated glycidylmethacrylate, β-methylglycidylmethacrylate, and allylglycidylether, etc.

Addition amount of the epoxy group-contained unsaturated compound to a portion of the acid groups in the present invention preferably ranges in 5-50 mol% based on the modified copolymer.

In the case that the addition amount is less than 5 mol%, ultraviolet ray curability is low, and physical properties tend to lower in a cured thin layer. Contrarily, in the case of exceeding 50 mol%, storage stability is apt to lower in the modified copolymer.

On the other hand, an acid value in the modified copolymer preferably ranges in 10-150 mgKOH/g. In the case that the acid value is less than 10 mgKOH/g, removal of an uncured thin layer by an aqueous alkali solution tends to become difficult and, in the case of exceeding 150 mgKOH/g, water resistance and electric properties tend to become gradually poorer in a cured layer.

Further, in the modified copolymer, a weight average molecular weight preferably ranges in 5,000-100,000.

In the case that the weight average molecular weight is less than 5,000, (1) a tackfree property is apt to lower, (2) moisture resistance of a coating layer tends to become readily worse after exposing to a light and, a thin layer is apt to decrease during development, and it is not regarded as a high resolution. Further, in the case that the weight average molecular weight exceeds 100,000, (1) a developability possibly becomes remarkably worse and, (2) storage stability begins to lower.

As catalysts to be employed in the case that the epoxy group-contained unsaturated compound is added to the copolymer in the present invention, there can be enumerated tertiary amines such as dimethyl benzyl amine, triethyl amine, tetramethylethylene diamine, and tri-n-octylamine; quaternary ammonium salts such as tetramethyl ammonium chloride, tetramethyl ammonium bromide, and tetrabutyl ammonium bromide; alkyl ureas such as tetramethyl urea; alkyl guanidines such as tetramethyl guanidine, metal compounds typified by cobalt naphthenate; organic metal complexes; phosphines such as triphenyl phosphine; and phosphine salts thereof, etc., and, there is preferably enumerated a tertiary phosphine typified by triphenyl phosphine. The catalysts may be employed solely or in combination of two or more kinds.

The catalysts are preferably employed in amount of 0.01-10% by weight, more preferably 0.5-3.0% by weight based on the epoxy group-contained unsaturated compound. In the case of less than 0.01% by weight, a catalytic effect is occasionally low and, even though being employed exceeding 10% by weight, a difference does not appear in the effect.

In the case of allowing to add the epoxy group-contained unsaturated compound, a solvent can be also employed, and as the solvent in the case, it is not particularly limited if it can dissolve raw materials. For example, there are employed aromatic hydrocarbons such as benzene, toluene, and xylene, alcohols such as methanol, ethanol, and 2-propanol, ketones such as acetone, methylethylketone and methyl isobutylketone, ethers such as diethylether, dibutylether, and dioxane, esters such as ethyl acetate, isobutyl acetate, and ethylene glycol monoacetate, propylene glycol monoacetate, dipropylene glycol monoacetate, alkylene glycol monoalkylethers such as ethylene glycol monoalkylethers, diethylene glycol monoalkylethers, propylene glycol monoalkylethers, dipropylene glycol monoalkylethers, and butylene glycol monoalkylethers, polyalkylene glycol polyalkyl ethers such as ethylene glycol dialkylethers, diethylene glycol dimethyl ether, diethylene glycol diethyl ether, mono or polyalkylene glycol dialkyl ether esters such as ethylene glycol monoalkyl ether acetate and diethylene glycol monoalkyl ether acetate, amides such as dimethylformamide and dimethylacetamide, halogenated hydrocarbons such as carbon tetrachloride and chloroform, and the like. The solvents may be employed solely or even in combination.

In the curable resin which is the modified polymer, other components can be added to prepare a useful curable resin composition, there is particularly useful a curable resin composition containing a photopolymerization initiator and a monomer or an oligomer for dilution.

As the photopolymerization initiator to be employed herein, there are benzophenone, acetophenone benzyl, benzyl dimethyl ketone, benzoin, benzoin methylether, benzoin ethylether, benzoin isoppropyl ether, dimethoxy acetophenone, dimethoxyphenyl acetophenone, diethoxy acetophenone, and diphenyl disulphide, etc., and those can be employed solely or in combination.

In the photopolymerization initiator, there can be also added a synergistic agent, for example, a tertiary amine in order to strengthen a conversion to a polymerization initiating free radical by photoabsorption energy. However, in the case that the curable resin composition of the present invention is cured by an electron beam irradiation, the addition of the polymerization initiator is not always required.

As the monomer or an oligomer for dilution, there can be enumerated a monomer having a radically-polymerizable double bond or oligomer from the monomer typified by an acrylate compound, a methacrylate compound, a vinyl aromatic compound such as styrene, and an amide-based unsaturated compound, etc.

Of those, as specific examples of the typical acrylate compound and methacrylate compound, there can be enumerated alkyl(meth)acrylates such as a methyl(meth)acrylate, ethyl(meth)acrylate, propyl(meth)acrylate, butyl(meth)acrylate, pentyl(meth)acrylate, and hexyl(meth)acrylate; (meth)acrylates having hydroxyl group such as 2-hydroxyethyl(meth)acrylate, hydroxypropyl(meth)acrylate, and hydroxybutyl(meth)acrylate, (meth)acrylates having hydroxyl group such as a caprolactone-modified 2-hydroxyethyl(meth)acrylate in which those are modified by caprolactone; etherglycol(meth)acrylates such as methoxy diethylene glycol(meth)acrylate, ethoxydiethylene glycol (meth)acrylate, isooctyloxydiethylene glycol(meth)acrylate, phenoxytriethylene glycol(meth)acrylate, methoxy triethylene glycol(meth)acrylate, methoxy polyethylene glycol#400-(meth)acrylate; difunctional (meth)acrylates such as 1,6-hexanediol di(meth)acrylate and neopentylglycol di(meth)acrylate, trifunctional (meth)acrylates such as trimethylolpropane tri(meth)acrylate which are a polyfunctional(meth)acrylate, etc.

As the oligomers, there can be exemplified (meth)acrylates of polyester polyols and (meth)acrylates of polyether polyols which are a polymerizable prepolymer, an adduct of a polyepoxide to a (meth)acrylic acid, and a resin in which a hydroxy(meth)acrylate is introduced into a polyol through a polyisocyanate, etc.

The above-described monomers or oligomers for dilution are preferably employed in the amount of 0.5-300 parts by weight, and more preferably 20-100 parts by weight based on 100 parts by weight of the modified copolymer. In the case that the amount of the monomers or oligomers for dilution is less than 0.5 part by weight, there is apt to be caused a problem that water resistance is remarkably poor in a cured coating layer. Further, in the case of exceeding 300 parts by weight, a characteristic of the modified copolymer tends to gradually decrease.

In the curable resin composition using the modified copolymer in the present invention, there is occasionally added an epoxy compound or an epoxy resin for the purpose of improving water resistance and electric properties, etc. in a cured coating layer.

As the epoxy compound or the epoxy resin to be added herein, for example, there can be enumerated an epoxidized resin having epoxy groups such as an epoxidized polybutadiene and an epoxidized butadiene-styrene block copolymer and, as commercially-supplied products thereof, there are Epolead PB and ESBS, etc. which are manufactured by Daicel Chemical Industries, Ltd. As cycloaliphatic epoxy resins, for example, there are Celloxide 2021 and EHPE which are manufactured by Daicel Chemical Industries, Ltd.; Epomic VG-3101 manufactured by Mitsui Kagaku, Ltd.; E-1031S manufactured by Yuka Shell Epoxy, Ltd.; TETRAD-X and TETRAD-C which are manufactured by Mitsubishi Gas Kagaku, Ltd.; and EPB-13 and EPB-27 which are manufactured by Nihon Soda, Ltd., etc. As polymerized type epoxy resins, for example, there are CP-50M and CP-50S manufactured by Nihon Yushi, Ltd. which are a copolymer of glycidylmethacrylate with styrene and a copolymer of glycidylmethacrylate with styrene and methylmethacrylate, or a copolymer of glycidylmethacrylate with cyclohexylmaleimide, etc.

Further, there can be enumerated an epoxy resin having a special structure, etc. and, as a novolak type epoxy resin, there are enumerated epoxy novolaks obtained by allowing to react epichlorohydrin and/or methyl epichlorohydrin with phenolic hydroxyl groups in novolaks obtained by allowing to react formaldehyde with phenols such as phenol, cresol, a halogenated phenol, and an alkyl phenol under the presence of acidic catalysts and, as commercially-supplied products thereof, there are EOCN-103, EOCN-104S, EOCN-1020, EOCN-1027, EPPN-201, and BREN-S which are manufactured by Nihon Kayaku, Ltd.; DEN-431 and DEN-439 which are manufactured by Dow Chemical, Ltd.; and N-73 and VH-4150 which are manufactured by Dainippon Ink Kagaku Kogyo, Ltd., etc. As bisphenol-type epoxy resin, there are a bisphenol-type epoxy resin obtained by allowing to react epichlorohydrin with bisphenols such as bisphenol A, bisphenol F, bisphenol S, and tetrabromo bisphenol A, and an epoxy resin obtained by allowing to react epichlorohydrin with a condensate of diglycidylether of bisphenol A with the above-described bisphenols and, as commercially-supplied products thereof, there are Epikote 1004 and Epikote 1002 manufactured by Yuka Shell, Ltd.; DER-330 and DER-337 which are manufactured by Dow Chemical, Ltd., etc. Further, there can be enumerated a trisphenol methane type epoxy resin obtained by allowing to react trisphenol methane and triscresol methane with epichlorohydrin and, as commercially-supplied products thereof, there can be also employed EPPN-501 and EPPN-502 manufactured by Yuka Shell Epoxy, Ltd., and tris(2,3-epoxypropyl)isocyanurate and biphenyl diglycidylether, etc.

The epoxy compounds or resins may be employed solely or in combination. The epoxy compounds, etc. are preferably employed in the amount of 0.5-100 parts by weight with respect to the modified copolymer in the present invention. In the case that the amount of the epoxy compounds is less than 0.5 part by weight, physical properties are insufficient in a cured coating layer and, in the case of exceeding 100 parts by weight, a characteristic of the modified copolymer tends to gradually decrease.

In the curable resin composition using the modified copolymer in the present invention, pigments can be optionally added.

As the pigments, for example, there can be employed pigments such as phthalocyanine green. It is to be noted that the addition amount of the pigments is preferably 0.01-500 parts by weight with respect to 100 parts by weight of the modified copolymer in the present invention.

In addition, the above-described composition can optionally contain additives such as a thermal polymerization inhibitor, a surface active agent, a photoabsorbent, a thixotropic agent, and a dye. Further, there can be also formulated a thermoplastic resin and thermosetting resin, etc.

The curable resin composition using the modified copolymer in the present invention can be cured by coating onto a base material as a thin layer. Herein, as a method for forming the thin layer, there are employed spray coating, brush coating, roll coating, curtain coating, electro-deposition coating, and electrostatic coating, etc. Further, although curing is preferably conducted under an inert gas atmosphere, it can be also conducted even under an air atmosphere.

The curable resin composition of the present invention can be utilized in wide industrial fields which include various coating fields such as usual inks, coatings for plastics, printing materials for paper, coatings materials for films, and coatings materials for furniture, FRP, and linings and, further, varnishes for insulation, sheets for insulation, lamination board, print circuit boards, resist inks, pigment resist inks for color filters, and encapsulation for semiconductors in electronics fields, etc.

Hereinafter, the No. II of the present invention is illustrated in detail.

The modified copolymer is obtained by addition of the epoxy group-contained unsaturated compound (CII) to a portion of acid groups in a copolymer (BII) having Tg of not less than 50°C obtained from a compound (AII) having a divalent group which can be bonded between an unsaturated group and carboxylic group and, a (meth)acrylic acid and a (meth)acrylate, and it constructs the curable resin.

In the present invention, photo- and/or thermal-sensitivity is elevated by introducing monomers units having a divalent group which can be bonded between an unsaturated group and carboxylic group into the modified copolymer structure, and a tack free property is simultaneously given.

As the compound (AII) having a divalent group which can be bonded between an unsaturated group and carboxylic group, for example, there are enumerated β-carboxyethyl(meth)acrylate, 2-acryloyloxyethyl succinic acid, 2-acryloyloxyethyl phthalic acid, 2-acryloyloxyethyl hexahydrophthalic acid, and a compound such as an unsaturated monocarboxylic acid having a lactone-modified ester bond and a modified unsaturated monocarboxylic acid having an ether bond.

As the unsaturated monocarboxylic acid having a lactone-modified ester bond and the modified unsaturated monocarboxylic acid having an ether bond, there are specifically enumerated the compounds, etc. illustrated in the No. I in the present invention.

In a viewpoint of capability of largely introducing the compound (AII) which maintains Tg of not less than 50°C in a resin by mixing with a (meth)acrylic acid and which has a divalent group which can be bonded between an unsaturated group and carboxylic group, and which is necessary for elevation of sensitivity, β-carboxyethyl(meth)acrylate is preferred.

The (meth)acrylic acid and the (meth)acrylate to be employed in the present invention are a generic name including methacrylic acid, acrylic acid, and esters thereof.

As the (meth)acrylate to be employed in the present invention, there are enumerated compounds exemplified as one of the comonomer components for the No. I in the present invention, cycloaliphatic alkyl(meth)acrylates such as adamantyl(meth)acrylate and norbonyl(meth)acrylate, and cycloaliphatic(meth)acrylates having a terminal hydroxyl group such as hydroxyadamantyl(meth)acrylate and hydroxynorbonyl(meth)acrylate, etc.

Further, there are optionally enumerated other monomers such as vinylphenols. Otherwise, there may be copolymerized a compound having at least two pieces of carboxylic groups in the molecule such as maleic acid. Also, those may be employed solely or even in combination.

By the addition of the epoxy group-contained unsaturated compound (CII) to a portion of acid groups in the copolymer (BII) obtained from the compound (AII) having a divalent group which can be bonded between an unsaturated group and carboxylic group, the modified copolymer can be obtained.

The epoxy group-contained unsaturated compound (CII) is a compound having one radically-polymerizable unsaturated group and a cycloaliphatic epoxy group in the molecule. Specifically, for example, there can be enumerated the various unsaturated compounds having a cycloaliphatic epoxy group represented by the general formula (4) exemplified for the No. I in the present invention. Of those, 3,4-epoxycyclohexyl methyl(meth)acrylate is preferably employed.

Further, there are enumerated aliphatic unsaturated group-contained compounds such as glycidylmethacrylate, β-glycidyl methacrylate, and allylglycidyl methacrylate. The epoxy group-contained unsaturated compounds may be employed solely or even in combination of two or more kinds.

Proportion of the compound (AII) which constructs the copolymer (BII) having a divalent group which can be bonded between an unsaturated group and carboxylic group, the (meth)acrylic acid, and the (meth)acrylate is 0.1-80/10-89/10-89.9 % by weight, preferably 1-80/10-80/10-80 % by weight. The copolymer (BII) has Tg (transition temperature) of not less than 50°C, preferably 50-200°C. In the case that Tg in the copolymer (BII) is less than 50°C, a tackfree property unpreferably lowers in the modified copolymer (a curable resin).

Addition amount of the epoxy group-contained unsaturated compound (CII) ranges in 5-99 equivalent, and preferably 30-90 equivalent based on carboxylic groups in the modified copolymer.

In the case that the addition amount is less than 5 equivalent, ultraviolet ray curability is worse and physical properties lower in a cured coating layer. In the case of exceeding 99 equivalent, storage stability becomes worse in the resin.

Catalysts to be employed in the addition of the epoxy group-contained unsaturated compound (CII) to the copolymer (BII), addition amount, and solvents to be employed in the addition reaction are the same as in the catalysts, addition amount, and solvents to be employed in the addition of the epoxy group-contained unsaturated compound to the copolymer exemplified for the No. I in the present invention. Conditions in the addition of the epoxy group-contained unsaturated compound (CII) are not particular and, the reaction is conducted at 50-120°C for 4-50 hours.

In thus-obtained modified copolymer, an acid value preferably ranges in 10-150 mgKOH/g, more preferably ranges in 30-130 mgKOH/g.

In the case that the acid value is less than 10 mgKOH/g, it is difficult to remove an uncured layer by a diluted aqueous alkali solution and, in the case of exceeding 150 mgKOH/g, water resistance and electric properties become possibly worse in a cured coating layer. Further, in the modified copolymer, a weight average molecular weight is 5,000-150,000, and preferably 5,000-100,000.

In the case that the weight average molecular weight is not more than 5,000, (1) a tackfree property occasionally becomes poor and, (2) a moisture property is worse in the coating layer after exposing to light and, a decrease of the coating layer is caused during development and resolution is occasionally poor largely.

Further, in the case that the weight average molecular weight is not less than 150,000, (1) developability is occasionally worse remarkably and, (2) storage stability occasionally becomes poor.

The curable resin of the present invention is composed of the modified copolymer.

From the curable resin and the monomer or oligomer for dilution, there can be obtained the curable resin composition which is soluble in a diluted aqueous alkali solution. The resin composition has beat curability or electron beam curability.

Further, from the curable resin, a photopolymerization initiator, and the monomer or oligomer for dilution, there can be obtained the curable resin composition which is soluble in a diluted aqueous alkali solution, and the composition has photocurability. The curable resin composition may further contain an epoxy compound and/or an epoxy resin, a resin in which an acid anhydride is added after modifying a novolak or bisphenol-based epoxy resin by a (meth)acrylic acid, and/or pigments

As the epoxy compound to be added, there are enumerated the epoxy compounds or the epoxy resins which are occasionally added for elevating water resistance and electric properties. Of the epoxy resins, the resin (an acid-modified epoxy resin) in which an acid anhydride is added after modifying a novolak or bisphenol-based epoxy resin by a (meth)acrylic acid can be also employed together with the curable resin. The epoxy resins and acid-modified epoxy resins may be employed solely or even in mixing. The epoxy compounds are employed in a necessary amount, for example, preferably 0-100 parts by weight, and more preferably 0-80 parts by weight based on 100 parts by weight of the modified copolymer. In the case that the amount of the epoxy compounds is more than 100 parts by weight, characteristics decrease in the curable resin.

As the photopolymerization initiator to be employed in the curable resin composition, there are enumerated the photopolymerization initiators exemplified for the No. I in the present invention. The photopolymerization initiators can contain a synergistic agent for strengthening a conversion of absorbed photo energy into a polymerization initiating free radical, for example, tertiary amines.

Use amount of the photopolymerization initiators is preferably 0.1-50 parts by weight, and more preferably 1-20 parts by weight based on 100 parts by weight of the curable resin. In the case that the curable resin composition of the present invention is cured by irradiation of an electron beam, addition of the photopolymerization initiators is not always required.

As the monomer or oligomer for dilution, there are enumerated the monomer or oligomer for dilution exemplified for the No. I in the present invention.

The monomer and oligomer for dilution can be formulated in a necessary amount, for example, preferably 1-300 parts by weight, and more preferably 1-100 parts by weight based on the use amount of 100 parts by weight of the modified copolymer (curable resin).

In the amount of the monomer and oligomer for dilution is more than 300 parts by weight, characteristics decrease in the curable resin composition.

In addition, the composition can optionally contain additives such as a thermal polymerization inhibitor, a surface active agent, a photoabsorbent, a thixotropic agent, and a dye. Further, there can be also formulated a thermoplastic resin and thermosetting resin, etc. The curable resin and the curable resin composition of the present invention can be cured by coating onto a base material as a thin layer. As a method for forming the thin layer, there are employed spray coating, brush coating, roll coating, curtain coating, electro deposition coating, and electrostatic coating, etc. Further, although curing is preferably performed under an inert gas atmosphere, it can be also performed even under an air atmosphere.

It is to be noted that an ultraviolet ray and electron beam, etc, are enumerated as light for photocuring.

The curable resin and the curable resin composition of the present invention can be utilized in wide industrial fields which include various coating fields such as usual inks, coatings for plastic, printing materials for paper, coatings materials for films, and coatings materials for furniture, FRP, and linings and, further, varnishes for insulation, sheets for insulation, lamination board, print circuit boards, resist inks, pigment resist inks for color filters, and encapsulation for semiconductors in electronics fields, etc.

Hereinafter, the No. III of the present invention is illustrated in detail.

The resin composition of the present invention comprises adding at least one of an acrylate monomer (eIII) having functional groups selected from acetoacetoxyethyl acrylate, acryloyl morpholine, and tetrahydrofurfuryl acrylate to a modified copolymer (BIII) obtained by addition of an epoxy group in an epoxy group-contained unsaturated compound (dIII) to a portion of acid groups in a copolymer (PIII-2) composed of β-carboxyethyl(meth)acrylate (aIII), an unsaturated compound having an acid group, and a (meth)acrylate (cIII), and it is referred to the resin composition (I).

Further, the modified copolymer (AIII) of the present invention is obtained by the addition of an epoxy group in an epoxy group-contained unsaturated compound (dIII) to a portion of acid groups in a copolymer (PIII-1) composed of β-carboxyethyl (meth)acrylate (aIII), an unsaturated compound (bIII) having an acid group, and a (meth)acrylate (CIII), at least one of an acrylate monomer (eIII) having functional groups selected from acetoacetoxyethyl acrylate, acryloyl morpholine, and tetrahydrofurfuryl acrylate, and it is referred to the modified copolymer (AIII).

First of all, there are illustrated raw materials employed in the No. III of the present invention.

### (aIII) β-carboxyethyl(meth)acrylate

β-carboxyethyl(meth)acrylate (aIII) is a compound having the following structure and, hereinafter, it is abbreviated as βCEA.

CH₂=CHCOOCH₂CH₂COOH

In the βCEA, since copolymerizable double bond is away from carboxylic group, in the unsaturated group of the epoxy group-contained unsaturated compound (dIII) which is reacted with the carboxylic group in the βCEA, steric hindrance is not apt to be caused by a polymer main chain. Accordingly, it is apt to be readily cured by an ultraviolet ray, resulting in that sensitivity becomes excellent.

### (bIII) Unsaturated compound having an acid group

The unsaturated compound (bIII) having an acid group is a compound having an unsaturated group and at least one acid groups, and there are enumerated acrylic acid, methacrylic acid (the formers are represented as (meth)acrylic acid), vinylphenols, maleic acid, and fumaric acid, etc., and methacrylic acid is particularly preferred. These may be employed even solely or in mixing.

### (cIII) (meth)acrylate

The (meth)acrylate (cIII) is a compound having (meth)acrylic structure and an aliphatic hydrocarbon structure and, specifically, there are enumerated ones exemplified in the No. II of the present invention.

Of those, methylmethacrylate is preferred.

### (dIII) Epoxy group-contained unsaturated compound

The epoxy group-contained unsaturated compound (dIII) is a cycloaliphatic epoxy group-contained unsaturated compound (dIII-1) having a radically-polymerizable unsaturated group and a cycloaliphatic epoxy group in the molecule or an aliphatic epoxy group-contained unsaturated compound (dIII-2), and those may be employed in mixing of two or more kinds.

As the cycloaliphatic epoxy group-contained unsaturated compound (dIII-1), there are exemplified compounds represented by general formulae (5)-(17) described below. (hereinafter, the page is blank)

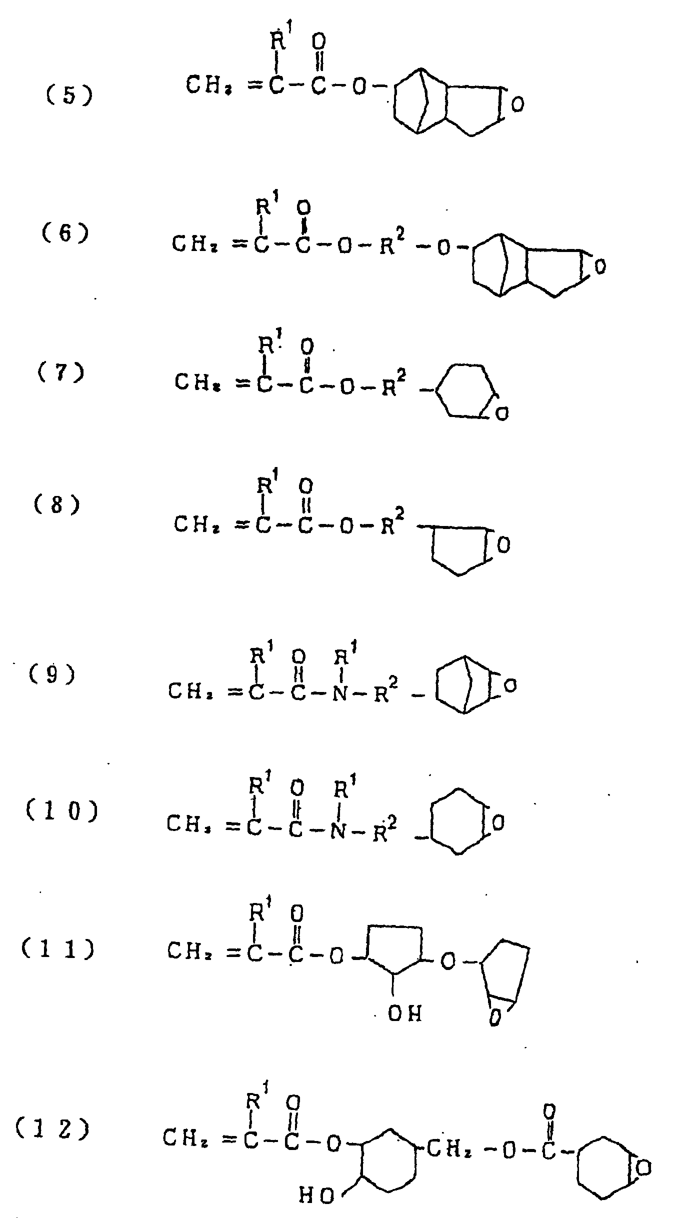

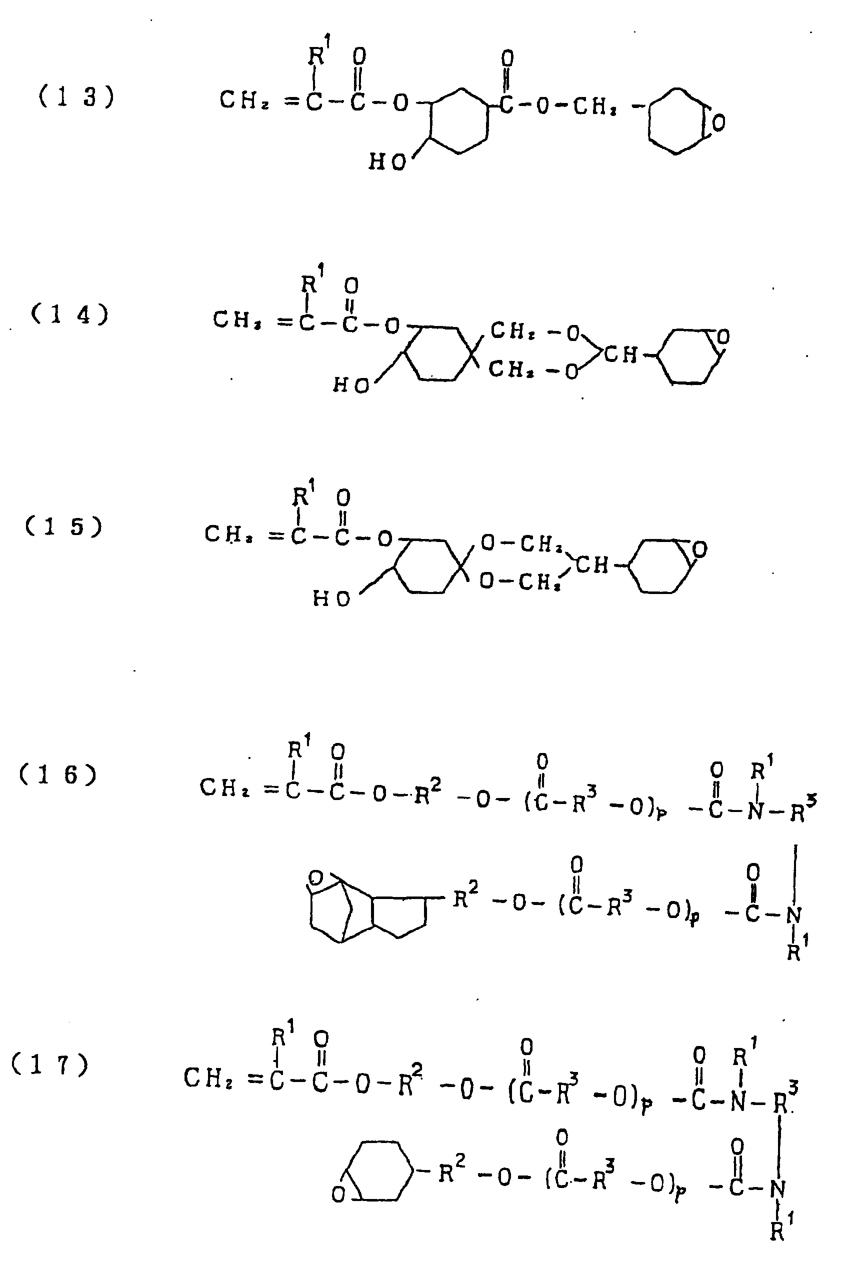

It is to be noted that in the formulae (5)-(17), R¹ is a hydrogen atom or methyl group, R² a divalent aliphatic saturated hydrocarbon group having a carbon number of 1-10, R³ is a divalent aliphatic saturated hydrocarbon group having a carbon number of 1-10, p is 0 or an integer of 1-10, respectively.

As the aliphatic epoxy group-contained unsaturated compound (dIII-2), there are exemplified glycidyl methacrylate, β-glycidyl methacrylate, and allylglycidyl methacrylate, etc.

### (eIII) Acrylate monomer containing functional groups

The acrylate monomer (eIII) containing functional groups is acetoacetoxyethyl acrylate, acryloyl morpholine, or tetrahydrofurfuryl acrylate, and those may be also employed in combination of two or more kinds.

The acrylate monomer (eIII) containing functional groups is effective for improving a plating-resistible property, sensitivity, and a finger touch dryability (also referred to a tackfree property), etc.

### (PIII-1) and (PIII-2) Copolymer

The copolymer (PIII-1) is obtained by copolymerizing double bond in the βCEA (aIII), the unsaturated compound (bIII) having acid groups, the (meth)acrylate (CIII), and the acrylate monomer (eIII) containing functional groups using a radically-polymerizable initiator, etc.

As composition ratio in the copolymer (PIII-1), the βCEA (aIII) is 0.6-50% by mol, and preferably 5-40% by mol, the unsaturated compound (bIII) having acid groups is 20-60% by mol, and preferably 30-60% by mol, the (meth)acrylate (cIII) is 80-30% by mol, and preferably 50-30% by mol (total of (aIII), (bIII), and (cIII) is 100% by mol), and the acrylate monomer (eIII) having functional groups is 1-50 parts by weight, and preferably 1-20 parts by weight based on 100 parts by weight of the total of (aIII), (bIII), and (cIII).

The copolymer (PIII-2) is obtained by allowing to copolymerize double bond in the βCEA (aIII), the unsaturated compound (bIII) having acid groups, the (meth)acrylate(cIII), and the acrylate monomer (eIII) having functional groups using a radically-polymerizable initiator, etc.

As composition ratio in the copolymer (PIII-2), the βCEA (aIII) is 2-50% by mol, and preferably 5-40% by mol, the unsaturated compound (bIII) having acid groups is 60-20% by mol, and preferably 60-30% by mol, the (meth)acrylate (cIII) is 80-30% by mol, and preferably 50-30% by mol (total of (aIII), (bIII), and (cIII) is 100% by mol).

In the copolymers (PIII-1) and (PIII-2), in the case that the ratio of the βCEA (aIII) is excessively less than 2% by mol, sensitivity becomes insufficient and, in the case of excessively more than 50% by mol, the finger touch dryability becomes worse.

Molar ratio of the βCEA (aIII) with respect to the unsaturated compound (bIII) having acid groups can be freely changed, and it ranges in preferably 1/99-70/30, and more preferably 5/95-20/80.

In the case that the molar ratio of the βCEA (aIII) is excessively less than 1, sensitivity largely lowers and, in the case that the molar ratio is excessively more than 1, finger touch dryability lowers.

In the copolymer (PIII-1), ratio of the acrylate monomer (eIII) having functional groups is excessively less than 1 part by weight, the plating resistible property becomes insufficient and, even in the case of excessively exceeding 50 parts by weight, an improvement of the plating resistible property is not observed and, finger touch dryability becomes worse.

Further, in the case of a resin composition comprising adding the acrylate monomer (eIII) having functional groups to the modified copolymer (BIII) described hereinafter obtained from the copolymer (PIII-2), the acrylate monomer (eIII) having functional groups is 1-50 parts by weight, and preferably 1-20 parts by weight based on 100 parts by weight of total of the (aIII), (bIII), and (cIII). In the case that ratio of the acrylate monomer (eIII) having functional groups is excessively less than 1 part by weight, the plating resistible property becomes insufficient and, even in the case of excessively exceeding 50 parts by weight, an improvement of the plating resistible property is not observed and, finger touch dryability becomes worse.

### (AIII) and (BIII) Modified copolymer

Hereinafter, there is illustrated a method for preparing the modified copolymers (AIII) and (BIII) from the above-described copolymer (PIII-1) or (PIII-2). For adding epoxy groups in the epoxy group-contained unsaturated compound (dIII) to a portion of acid groups in the copolymers (PIII-1) or (PIII-2), the copolymer (PIII-1) or (PIII-2) is dissolved in solvents, followed by conducting a ring-opening addition reaction under the presence of catalysts.

Addition amount of the epoxy group-contained unsaturated compound (dIII) desirably ranges in 5-50% by mol (that is, (dIII)/((aIII)+(bIII)+(cIII))x100% ranges in 5-50% by mol) based on mol composition ratio of the modified copolymer (AIII) or (BIII) obtained. In the case that the addition amount is excessively less than 5%, curability becomes worse, resulting in that physical properties lower in a cured thin layer. In the case of excessively more than 50%, storage stability becomes worse in the modified copolymers or a resin composition therefrom in the present invention.

An acid value and a molecular weight in thus-obtained modified copolymer (AIII) or (BIII) preferably range in the range of the modified copolymer in the No. I of the present invention from the same reason.

As a solvent for dissolving the copolymer (PIII-1) or (PIII-2), if it dissolves the copolymer (PIII-1) or (PIII-2), it is not limited and, for example, there are enumerated solvents exemplified as the solvents to be employed in the case of adding the epoxy group-contained unsaturated compound in the No. I of the present invention. Preferably, there are enumerated propylene glycol monomethyl ether and dipropylene glycol monomethyl ether, etc. The solvents may be employed solely or in mixing.

Catalysts for the ring-opening addition reaction of an epoxy group in an epoxy group-contained unsaturated compound (dIII) to carboxylic groups in a copolymer (PIII-1) or (PIII-2), and the use amount are the same as in the catalysts to be employed for the addition of the epoxy group-contained unsaturated compound in the No.I of the present invention.

The modified copolymer (AIII) is employed as a resin for a resist without any modifications, and the modified copolymer (BIII) is employed as a resin composition (I) for a resist by adding the acrylate monomer (eIII) having functional groups.

The modified copolymer (AIII) and the resin composition (I) can be employed in mixing.

### (DIII) Other epoxy compounds

In the modified copolymer (AIII) and/or the resin composition (I), the other epoxy compounds (DIII) can be added. As specific examples of the other epoxy compounds (DIII), there are enumerated epoxy compounds or epoxy resins which are occasionally added for the purpose of elevating water resistance and electric properties of the cured coating layer in the curable resin composition of the No. I of the present invention.

Addition amount of the other epoxy compounds (DIII) is 0-100 parts by weight based on 100 parts by weight of the modified copolymer (AIII) and/or the resin composition (I). In the case that the addition amount of the other epoxy compounds (DIII) is excessively more than 100 parts by weight, solubility of unexposed portions by a developer lowers in the case of an alkali development type, resulting in that residual portions in development are apt to be readily caused and becomes difficult in a practical use.

### (EIII) Other compounds having an unsaturated group and an acid group

In the modified copolymer (AIII) and/or the resin composition (I), there can be added compounds or resins having an unsaturated group and an acid group (both are referred to as other compounds having an unsaturated group and an acid group (EIII)) in which an acid anhydride is added after modifying the other epoxy compounds (DIII) by a (meth)acrylic acid.

The other compounds having an unsaturated group and an acid group (EIII) can be also employed together with the other epoxy compounds (DIII).

As the other compounds having an unsaturated group and an acid group (EIII), there is preferred a resin in which an acid anhydride such as tetrahydrophthalic anhydride, phthalic anhydride, and maleic anhydride is added after modifying a novolak-based epoxy resin and/or a bisphenol-based epoxy resin by a (meth)acrylic acid.

Addition amount of the other compounds having an unsaturated group and an acid group (EIII) is 0-1,000 parts by weight based on 100 parts by weight of the modified copolymer (AIII) and/or the resin composition (I). In the case that the addition amount of the other compounds having an unsaturated group and an acid group (EIII) is more than 1,000 parts by weight, finger touch dryability becomes problematic.

### (II) Photo-sensitive or heat-sensitive resin composition

In order to obtain the photo-sensitive or heat-sensitive resin composition (hereinafter, both are referred to as the photo-sensitive or heat-sensitive resin composition (II)) using the modified copolymer (AIII) and/or the resin composition (I), there are usually added a photo-polymerization initiator (FIII), or a thermal-polymerization initiator (F'III), and a diluent, and optionally, other additives (HIII), etc.

It is to be noted that in the case of curing the modified copolymer (AIII) and/or the resin composition (I) of the present invention by an electron beam, it is not always required to add the photo-polymerization initiator (FIII), or the thermal-polymerization initiator (F'III).

### (FIII) Photo-polymerization initiator

The photo-polymerization initiator (FIII) is added for quickly curing the photo-sensitive resin composition according to a pattern by ultraviolet ray or an electron beam.

As specific examples of the photo-polymerization initiator (FIII), there are enumerated the same initiators as exemplified in the No. I of the present invention.

Addition amount of the photo-polymerization initiator (FIII) appropriately ranges in 0.05-30 parts by weight based on 100 parts by weight of the modified copolymer (AIII) and/or the resin composition (I).

In the photopolymerization initiator (FIII), there may be also added a synergistic agent in order to strengthen a conversion to a polymerization initiating free radical by photoabsorption energy, for example, a tertiary amine such as triethyl amine, triethanol amine, and 2-diethylaminoethanol; trialkyl or aryl phosphines such as triphenyl phosphine; and a thiol such as β-thioglycol, etc.

### (F'III) Thermal-polymerization initiator

The thermal-polymerization initiator (F'III) is added for curing the photo-sensitive resin composition by heating.

AS the thermal-polymerization initiator (F'III), there are enumerated an azo-based initiator such as 2,2'-azobis(2-methylbutyro)nitrile and a peroxide-based initiator such as t-butylperoxy-2 -ethylhexanoate, etc.

Addition amount of the thermal-polymerization initiator (F'III) ranges in 0.05-30 parts by weight based on 100 parts by weight of the modified copolymer (AIII) and/or the resin composition (I).

### (GIII) Diluent

The diluent (GIII) is employed for adjusting to a viscosity as being capable of readily coating the modified copolymer (AIII) and/or the resin composition (I) by diluting, and elevating polymerizability.

As the diluent (GIII), there are employed a monomer (GIII-1) for dilution, an oligomer (GIII-2) for dilution, organic solvents, and a mixture thereof.

The monomer (GIII-1) for dilution includes a (meth)acrylate, vinyl aromatic compound such as styrene and a compound having a radically-polymerizable double bond such as an amide-based unsaturated compound. As the (meth)acrylate, there are enumerated the (meth)acrylates exemplified as a monomer for dilution in the No. I of the present invention.

As the oligomer (GIII-2) for dilution, for example, there are enumerated the oligomers enumerated as the oligomer for dilution in the No. I of the present invention.

As the organic solvents, there are enumerated ketones such as methyl ethyl ketone and methyl isobutyl ketone; aromatic hydrocarbons such as benzene, toluene, xylene, and tetramethyl benzene; glycol ethers such as methyl cellosolve, ethyl cellosolve, butyl cellosolve, methyl carbitol, butyl carbitol, propylene glycol monomethylether, diethylene glycol monoethylether, dipropylene glycol monoethyl ether, and triethylene glycol monoethyl ether; esters such as ethyl acetate, butyl acetate, and cellosolve acetate dipropylene glycol monoethyl etheracetate, and esterified products of the glycol ethers; alcohols such as ethanol, propanol, ethylene glycol, and propylene glycol; aliphatic hydrocarbons such as octane and decane; and petroleum-based solvents such as a petroleum ether, a petroleum naphtha, a hydrogenated petroleum naphtha, and a solvent naphtha, etc.

Such the diluents (GIII) can be employed solely or in combination of two or more kinds.

Addition amount of the diluents (GIII) ranges in 0-300 parts by weight, and preferably 0-100 parts by weight based on 100 parts by weight of the modified copolymer (AIII) and/or the resin composition (I). In the case that the addition amount of the diluents (GIII) is more than 300 parts by weight, a characteristic of a tackfree property lowers in the modified copolymer (AIII) and/or the resin composition (I).

### (HIII) Other additives

As the other additives (HIII) to be optionally added, there can be enumerated latent adhesion agents for curing, inorganic fillers, thermal polymerization inhibitors, surface active agents, photo-absorbents, thixotropic agents, coloring agents such as dyes and pigments, thermoplastic resins and thermosetting resins, etc.

As the latent adhesion agents for curing, there are enumerated an S-triazine compound such as melamine, ethyl-diamino-S-triazine, 2, 4-diamino-S-triazine, 2,4-diamino-6-tollyl-S-triazine, 2,4-diamino-6-xylyl-S-triazine, and derivatives thereof; guanamines such as guanamine, acetoguanamine, benzoguanamine, and 3,9-bis[2-(3,5-diamino-2,4,5-triazaphenyl)ethyl]2,4,8,10-tetraoxaspyro[5,5]undecane; imidazole and derivatives thereof such as 2HZ, 2E4HZ, C11Z, C17Z, 2PZ, 1B2HZ, 2HZ-CN, 2E4HZ-CN, C11Z-CN, 2PZ-CN, 2P11Z-CN, 2HZ-CNS, 2E4HZ-CNS, 2PZ-CNS, 2HZ-AZINE, 2E4HZ-AZINE, C11Z-AZINE, 2MA-OK, 2P4MHZ, 2PHZ, and 2P4BHZ which are manufactured by Shikoku Kasei Kogyo, Ltd.; polyamines such as diaminodiphenyl methane, m-phenylenediamine, diaminodiphenyl sulphone, cyclohexylamine, m-xylylene diamine, 4,4'-diamino-3,3'-diethyldiphenyl methane, diethylene triamine, tetraethylene pentamine, N-aminoethyl piperazine, isophorone diamine, dicyandiamide, urea, urea derivatives, and a polybasic hydrazide, and organic acid salts thereof and/or epoxy adducts thereof; amine complexes of boron trifluoride; tertiary amines such as trimethyl amine, triethanol amine, N,N-dioctyl amine, N,N-dimethyl aniline, N-benzyl dimethyl amine, pyridine, N-methyl pyridine, N-methyl morpholine, hexamethoxymethyl melamine, 2,4,6-tris(dimethylaminophenol), N-cyclohexyl dimethyl amine, tetramethyl guanidine, and m-aminophenol; organic phosphines such as tributyl phosphine, triphenyl phosphine, and tris-2-cyanoethyl phosphine; phosphonium salts such as tri-n-butyl(2,5-dihydroxyphenyl)phosphonium bromide and hexadecyl tributyl phosphonium chloride; quaternary ammonium salts such as benzyl trimethyl ammonium chloride, phenyl tributyl ammonium chloride, and benzyl trimethyl ammonium bromide; photocationic polymerization catalysts such as diphenyl iodonium tetrafluoroborate, triphenyl sulphonium hexafluoroantimonate, 2,4,6-triphenyl thiopirilium hexafluorophosphate, and Irugacure 261 manufactured by Ciba Speciality Chemicals, Ltd.; and a styrenemaleic acid resin, and a silane coupling agent, etc., and the S-triazine compound is preferably employed from a viewpoint of an improvement of an adhesive property, adhesion, and plating-resistible property.

Such the latent adhesion agents for curing can be employed solely or in combination of two or more kinds, and addition amount is preferably 0.05-15 parts by weight based on 100 parts by weight of the modified copolymer (AIII) and/or the resin composition (I).

As the inorganic fillers which are optionally added for the purpose of improving properties such as adhesion and hardness, there are enumerated barium sulphate, barium titanate, silicone oxide, amorphous silica, talc, clay, magnesium carbonate, calcium carbonate, aluminum oxide, aluminum hydroxide, and mica, etc.

Mixing amount is 0-60% by weight, and preferably 5-40% by weight in the photosensitive or thermally-sensitive resin composition (II).

As the thermal polymerization inhibitors, there are enumerated hydroquinone, hydroquinone monomethyl ether, tert-butyl catechol, pyrogallol, and phenothiazine, etc. which are publicly-known thermal polymerization inhibitors.

As the coloring agents, there are enumerated phthalocyanine blue, phthalocyanine green, iodine green, disazoyellow, crystal violet, titanium oxide, carbon black, and naphthalene black, etc.

As thickener, there are enumerated orbene, bentone, and montmorillonite, etc.

Further, there can be mixed silicone-based, fluorine-based, mineral oil-based, and acrylic copolymer-based defoaming agents, leveling agents, anti-oxidants which are publicly-known additives, etc.

As the thermosetting resins, there are enumerated a diallyl phthalate prepolymer and a diallyl isophthalate prepolymer, etc., and those are employed as organic fillers. Chemical resistance can be improved by the addition thereof. Addition amount of the organic fillers is not more than 30 parts by weight, and preferably not more than 20 parts by weight based on 100 parts by weight of the modified copolymer (AIII) and/or the resin composition (I).

As the prepolymer, there are enumerated Daiso Dap and Daiso Isodap manufactured by Daiso, Ltd., there are preferably employed ones having an average molecular weight of 2,000-30,000. Of those, there is preferred a diallyl isophthalate prepolymer having an average molecular weight of 5,000-20,000.

As the thermoplastic resins, there can be mixed copolymers of an ethylenic unsaturated compound such as an acrylate, polyester resins synthesized from polyvalent alcohols and saturated or unsaturated polybasic compounds which are publicly-known binder resins, polyester(meth)acrylates synthesized from polyvalent alcohols, saturated or unsaturated polybasic compounds, and glycidyl methacrylate, urethane(meth)acrylates synthesized from polyvalent alcohols, diisocyanates, and (meth)acrylates having hydroxyl group which are publicly-known photosensitive oligomers within a range in which those do not affect to various properties as a solder resist mask.

However, of the above-described components, the binder resins such as copolymers of an ethylenic unsaturated compound such as an acrylate and the polyester resins are employed in use amount of not more than 10% by weight (not more than 5% by weight based on total of the resin composition (II)) based on 100 parts by weight of the modified copolymer (AIII) and/or the resin composition (I) because there is caused a problem that developability and sensitivity become worse in the case of employing the copolymers and binder resins not containing photosensitive groups which are publicly-known in a large amount.

As a method for forming a thin layer of the resin composition (II) such as a photoresist onto a base plate, there are employed a spraying method, brushing method, roll coating method, curtain coating method, electro-deposition coating method, and electrostatic coating method which are already known.

The base plate on which the thin layer is coated in a desired thickness is predried at 50-80°C for 15-60 minutes, followed by selectively exposing to light through a photomask by an active energy ray such as an ultraviolet ray, X ray, and electron beam, whereby, a resin exposed to light is polymerized and a resin unexposed to light is dissolved and removed to form a resist pattern by a developer. After that, post curing is performed by an ultraviolet ray, heating at 100-200°C, or far infrared rays to obtain a print circuit board having a desired resist pattern.

Although curing is preferably performed under an inert gas atmosphere, it can be also performed under an air atmosphere.

As the developer, an alkali aqueous solution and organic solvents are enumerated, and an alkali aqueous solution is preferred.

As the alkali aqueous solution, there are enumerated an alkali aqueous solution of potassium hydroxide, sodium hydroxide, sodium carbonate, potassium carbonate, sodium phosphate, sodium silicate, ammonia, amines, and a surfactant aqueous solution thereof.

As a diluted alkali aqueous solution, there is usually employed a sodium carbonate of 0.5-5% by weight.

As specific examples of the organic solvents, there are enumerated cyclohexanone, xylene, tetramethylbenzene, butyl cellosolve, butyl carbitol, propylene glycol monomethylether, cellosolve acetate, propanol, propylene glycol, trichloroethane, trichloroethylene, and modified trichloroethane, etc.

The modified copolymer (AIII) and/or the resin composition (I) according to the present invention can be utilized in wide industrial fields which include various coating fields such as inks, coatings for plastic, printing materials for paper, coatings materials for films, and coatings materials for furniture, FRP, and linings and, further, varnishes for insulation, sheets for insulation, lamination boards, printed boards, resist inks, a liquid resist, a dry film, a color filter employing for a liquid crystal display, a pigment resist for a black matrix, additives for preventing coating layers, a pigment resist ink for a color filter, and an encapsulant for semiconductors in electronics fields, etc.

Hereinafter, the No. IV of the present invention is illustrated.

The composition of the present invention is constructed by components and composition ratio described below.

The composition ratio of (BIV) and (CIV) is based on 100 parts by weight of the copolymer resin (AIV), and the composition ratio of (FIV), (GIV), and (HIV) is based on 100 parts by weight of the glass frit (EIV).

The components (EIV), (FIV), (GIV), and (HIV) are formulated in the ratio of 0.1-50 times, preferably 0.5-10 times with respect to sum of the (AIV), (BIV), and (CIV).
(AIV) Copolymer resin obtained by addition of the cycloaliphatic epoxy group-contained unsaturated compound (dIV) to a portion of acid groups in the copolymer (cIV) obtained from the (meth)acrylic acid (aIV) and the compound (bIV) having an unsaturated group and at least one acid groups under the presence of catalysts.
(BIV) Photopolymerization initiator: 1-50 parts by weight, preferably 5-20 parts by weight.
(CIV) Photopolymerizable monomer: 1-100 parts by weight, preferably 20-100 parts by weight.
(DIV) Solvent for dilution: It can be formulated in an appropriate weight proportion according to a coating method of a paste. Further, there can be also formulated an acrylic-based and silicone-based defoaming agent or a leveling agent.
(EIV) Glass frit: 10-1,000 parts by weight, preferably 50-500 parts by weight.
(FIV) Phosphorus compound: 0.1-100 parts by weight, preferably 0.5-2 parts by weight.
(GIV) Ceramic powder: 0.1-300 parts by weight, preferably 1-100 parts by weight. In a more preferred embodiment, a black-colored dye (HIV) is formulated.
(HIV) Black-colored dye, preferably a metal oxide black-colored dye primarily containing at least one oxides such as Fe, Cr, Mn, and Co: 1-300 parts by weight, preferably 3-100 parts by weight.

In the case that the photopolymerization initiator (BIV) is less than the above range, curing becomes insufficient and, in the case of exceeding the above range, storage stability lacks.

In the case that the photopolymerizable monomer (CIV) is less than the above range, curing becomes insufficient and, in the case of exceeding the above range, resolution lowers and storage stability lacks.

In the case that the phosphorus compound (FIV) is less than the above range, strength of a partition becomes insufficient after calcination and, in the case of exceeding the above range, curing becomes insufficient.

In the case that the ceramic powder (GIV) is less than the above range, strength of cell barriers becomes insufficient after calcination and, in the case of exceeding the above range, curing becomes insufficient.

In the case that the black-colored dye (HIV) is less than the above range, functions are not shown by light transmission caused through the cell barriers after calcination and, in the case of exceeding the above range, curing becomes insufficient.

Further, in the case that the total sum of (EIV), (FIV), (GIV), and (HIV) is less than the above range based on the total sum of (AIV), (BIV), and (CIV), strength of the cell barriers becomes insufficient after calcinatlon and, in the case of exceeding the above range, curing becomes insufficient.

The copolymer resin (AIV) to be employed in the glass paste composition of the present invention is a modified copolymer in which a mixture composed of the cycloaliphatic epoxy group-contained unsaturated compound (dIV) and the aliphatic epoxy group-contained unsaturated compound (d'IV) such as glycidyl methacrylate is added to a portion of acid groups in the copolymer (cIV) obtained from the (meth)acrylic acid (aIV) and the compound (bIV) having an unsaturated group and at least one acid groups.

As the (meth)acrylic acid (aIV), there are enumerated the (meth)acrylic acids exemplified as main comonomer components in the No. I of the present invention.

As the compound (bIV) having an unsaturated group and at least one acid groups, there are enumerated a (meth)acrylic acid; vinylphenol; a modified monocarboxylic acid in which a chain is extended between an unsaturated group and carboxylic group, for example, β-carboxyethyl(meth)acrylate, 2-acryloyloxyethyl succinic acid, and 2-acryloyloxyethyl hexahydrophthalic acid; and the modified monocarboxylic acids represented by the above-described general formulae (1)-(3) in the present invention.

Subsequently, by the addition of the epoxy group-contained unsaturated compound (dIV) to acid groups in the copolymer (cIV) obtained from the monomers, a copolymer which is the component (AIV) is obtained. Preparation of the copolymer which is the component (AIV) is performed according to the conditions for the preparation of the modified copolymer in the No. I of the present invention.

The cycloaliphatic epoxy group-contained unsaturated compound (dIV) is a compound having one radically-polymerizable unsaturated group and a cycloaliphatic epoxy group in the molecule.

Specifically, for example, there are enumerated the cycloaliphatic epoxy group-contained unsaturated compounds represented by the above-described general formula (4) exemplified in the No. I of the present invention.

The epoxy group-contained unsaturated compounds (dIV) may be employed solely or in combination of two or more.

In the cycloaliphatic epoxy group-contained unsaturated compounds (dIV), the cycloaliphatic epoxy group-contained unsaturated compounds (d'IV) can be mixed.

The epoxy group-contained aliphatic unsaturated compounds (d'IV) is a compound having one radically-polymerizable unsaturated group and an aliphatic epoxy group in the molecule and, specifically, there are enumerated the aliphatic unsaturated compounds exemplified in the No. I of the present invention.

The epoxy group-contained aliphatic unsaturated compounds (d'IV) may be employed solely or in combination together with the (dIV).

In the case that the epoxy group-contained aliphatic unsaturated compounds (d'IV) are mixed with the cycloaliphatic epoxy group-contained unsaturated compounds (dIV), those are employed in amount of 0-100 parts by weight, and preferably 0-50 parts by weight based on 100 parts by weight of the cycloaliphatic epoxy group-contained unsaturated compounds (dIV).

In the copolymer resin (AIV) obtained, a weight average molecular weight is 5,000-50,000, and preferably 6,000-30,000 and, an acid value is 50-150 mgKOH/g, and preferably 80-150 mgKOH/g, and double bond equivalent (a resin weight (g) based on 1 mol of an unsaturated group) is 400-2,000, and preferably 800-1,500.

In the case that the molecular weight is less than 5,000 in the copolymer resin (AIV), adhesion of a glass coating layer is adversely affected in development and, on the other hand, in the case of more than 50,000, developability is deteriorated and inferiority of development is unpreferably apt to be readily caused.

In the case of employing a unitary copolymer resin (AIV), when the acid value is less than 50 mgKOH/g, developability is deteriorated and inferiority of development is unpreferably apt to be readily caused and, on the other hand, when it is more than 150 mgKOH/g, there unpreferably lowers adhesion of a glass coating layer during development and, solution is unpreferably caused in a photo-cured portion (a portion exposed to light).

In the case of employing a mixed copolymer resin (AIV), a resin having an acid value of not more than 100 mgKOH/g, that is, an acid value of 0-100 mgKOH/g is mixed with a resin having an acid value of not less than 100 mgKOH/g, preferably 100-250 mgKOH/g. An acid value in the mixed resin is 50-150 mgKOH/g.

Further, the double bond equivalent is less than 400, residual substances are apt to be readily remained in calcination and, on the other hand, in the case of being more than 2,000, allowance in working for development is narrow, and a high exposing amount is unpreferably required in photocuring.

As the photopolymerization initiator (BIV), there can be employed solely or in combination of two or more photopolymerization initiators such as benzoin; benzoin alkyl ethers such as benzoin methyl ether, benzoin ethyl ether, and benzoin propyl ether; aromatic acyl compounds such as acetophenone, 2,2-dimethoxy-2-phenyl acetophenone, 2,2-diethoxy-2-phenyl acetophenone, 1,1-dichloro acetophenone, 2-methyl-1-[4-(methylthio)phenyl]-2-morpholino-propane-1-on, and 2-benzyl-2-dimethylamino-1-(4-morpholinophenyl)-butane-1-on;anthraquinones such as 2-methyl anthraquinone, 2-ethyl anthraquinone, 2-tertiarybutyl anthraquinone, 1-chloro anthraquinone, and 2-amyl anthraquinone; thioxanthones such as 2,4-dimethyl thioxanthone, 2,4-diethyl thioxanthone, 2-chlorothioxanthone, and 2,4-isopropyl thioxanthone; ketals such as acetophenone dimethyl ketal and benzyl dimethyl ketal; benzophenones; xanthones; and 1,7-bis(9-acrydinyl)heptane, etc. which are publicly-known and commonly employed.

Further, the photopolymerization initiators (BIV) can be employed in combination with one or more photosensitive accelerators such as tertiary amines which are publicly-known and commonly employed, which include N,N-dimethyl aminoethyl benzoate, N,N-dimethyl aminoisoamyl benzoate, pentyl-4-dimethylamino benzoate, triethylamine, and triethanol amine, etc.

In the composition of the present invention, the photopolymerizable monomer (CIV) is employed for accelerating photocurability of the composition and for elevating developability.

As the photopolymerizable monomer (CIV), there are employed 2-hydroxyethyl acrylate, 2-hydroxypropyl acrylate, diethylene glycol diacrylate, triethylene glycol diacrylate, polyethylene glycol diacrylate, a polyurethane diacrylate, trimethylolpropane diacrylate, pentaerythritol triacrylate, pentaerythritol tetraacrylate, trimethylolpropane-ethylene oxide-modified triacrylate, dipentaerythritol pentacrylate, dipentaerythritol hexacrylate, and respective methacrylates corresponding to the above-acrylates, and a mono-, di-, tri-, or more polyester of a polybasic acid with a hydroxyalkyl (meth)acrylate, and those can be employed solely or in combination of two or more kinds.

The solvent (DIV) for dilution to be employed for the composition of the present invention is employed for pasting the composition by dilution, whereby, coating can be readily performed and, a thin layer is formed by drying, whereby, enables to perform contact exposure to light. The use amount of the solvent (DIV) for dilution is very less compared to the use amount of conventional organic solvents in development and, since the solvent (DIV) for dilution is removed by drying and it is not carried in a development process, a problem concerning working circumstances can be largely improved.

The solvent (DIV) for dilution is formulated in an appropriate proportion of the amount so that a desired viscosity is obtained in a paste according to a method for coating the paste.

As the solvent (DIV) for dilution, there can be likewise employed the solvent to be employed in a preparing step of the copolymeric resin (AIV) as it is.

Specifically, there are enumerated ketones such as methyl ethyl ketone and cyclohexanone; aromatic hydrocarbons such as toluene, xylene, and tetramethylbenzene; glycol ethers such as cellosolve, methyl cellosolve, carbitol, methyl carbitol, butyl carbitol, glycol ethers such as propylene glycol monomethyl ether, dipropylene glycol monoethyl ethers, and triethylene glycol monoethyl ethers; acetates such as ethyl acetate, butyl acetate, cellosolve acetate, and butyl cellosolve acetate, carbitol acetate, butyl carbitol acetate, and propylene glycol monomethyl ether acetate; alcohols such as ethanol, propanol, ethylene glycol, and dipropylene glycol; aliphatic hydrocarbons such as octane and decane; and petroleum-based solvents such as a petroleum ether, a petroleum naphtha, a hydrogenated petroleum naphtha, and a solvent naphtha, etc. These can be employed solely or in combination of two or more kinds.

Further, in the solvent (DIV) for dilution, there can be also added an acrylic-based and silicone-based defoaming agent, and a levelling agent.

Specifically, there are enumerated BYK series ones manufactured by Bickchemy Japan, Ltd., etc.

Composition (%) of the glass frit (EIV) is preferably PbO:60-80%, B₂O₃:1-20%, SiO₂:1-15%, Al₂O₃:1-10% (the total of these is 100%).

Still further, from a viewpoint of resolution, there are preferred ones having an average particle diameter of not more than 20 µm, and preferably 5 µm.

Further, in the glass frit (EIV), there are preferred ones having a volume expansion coefficient of α(300°C)=70-90x10⁻⁷/°C and glass transition point of 300-550°C in a glass obtained by calcination.

In the composition of the present invention, the phosphoric acid compound (FIV) can be optionally added in a proportion of 0,1-5 parts by weight based on 100 parts by weight of the glass frit (EIV) for the purpose of elevating viscosity stability (storage stability).

As the phosphoric acid compound (FIV), there are enumerated phosphoric acid, phosphorous acid, mono(2-methacryloyloxyethyl) acid phosphate, di(2-methacryloyloxyethyl)acid phosphate, and di(2-acryloyloxyethyl)acid phosphate, etc., and which can be employed solely or in combination of two or more kinds.

As the above-described ceramic powder (GIV), there can be employed various ceramic powder such as alumina, mulite, corjerite, zircon, zirconia, and lead titanate, etc.

Still further, in the glass paste composition of the present invention, the black-colored pigment (HIV) can be added in a proportion of 3-100 parts by weight based on 100 parts by weight of the glass frit (EIV) in order to prevent halation in exposing to light and in order to elevate blackness degree of the cell barriers after calcination.

As the black-colored pigment (HIV), there can be preferably employed a metal oxide primarily containing at least one or more kinds of Fe, Cr, Mn, and Co.

Average particle diameter in the black-colored pigment (HIV) is not more than 20 µm, and preferably 5 µm from a viewpoint of resolution.

The glass paste composition of the present invention is coated on a glass base plate of a plasma display panel by an appropriate coating method such as a screen printing method, a bar coater method, and a blade coated method, etc.

Subsequently, the solvents for dilution are evaporated in a heated air circulating dryer, etc. in order to obtain a finger touch dryability.

After coating like that, a step for exposure to light and a step for development are performed one time or more times to form a cell barriers pattern having a desired thickness and aspect ratio, followed by calcining.

As the step exposing to light, there can be performed a contact exposure and a noncontact exposure using a photomask having a desired exposing pattern, and the contact exposure is preferred from a viewpoint of resolution.

Further, exposure conditions in vacuo or nitrogen atmosphere are preferred. As light sources for exposure, there are employed a halogen lamp, a high pressure mercury lamp, a laser beam lamp, a metal halide lamp, a black lamp, and an electrodeless lamp, etc.

In the development step, there are employed a spraying method and an immersion method, etc. As a developer, there are preferably employed an aqueous solution of an alkali metal hydroxide such as sodium hydroxide, potassium hydroxide, sodium carbonate, potassium carbonate, and sodium silicate, and an aqueous solution of an amine such as monoethanolamine, diethanolamine, and triethanolamine, and if a noncured portion (an unexposed portion) can be removed by saponification and solution of the copolymer resin (AIV) in the composition, it is not limited to such the above-described developers. Further, water washing and neutralization by acids are preferably performed in order to remove unnecessary developer after development.

In a step for calcination, a base plate after development is heated at 450-600°C in an air or nitrogen atmosphere to form a cell barriers pattern. At that time, there is preferably added a step in which organic components such as resins are burned and removed by heating at 400-500°C in an air.

By the use of the alkali-developable type photocurable glass paste composition of the present invention, there is not caused a problem such as a change for the worse in working circumstances, etc., and there can be stably formed a cell barriers pattern having a high precision in an excellent yield and productivity onto a base plate for a plasma display panel having a large area.

### Examples

Hereinafter, the present invention is more specifically illustrated by Examples. However, the present invention is not limited to the Examples.

In the following descriptions, "%" and "part" are shown by "% by weight" and "part by weight", respectively, not so far as particularly described.

It is to be noted that evaluations are according to the following methods.

### Finger touch dryability test:

After completion of drying, tackiness was evaluated by finger touch according to the following standards.
- ○:: tackiness was not observed
- △:: tackiness was lightly observed
- X:: tackiness was observed

### Sensitivity test:

It was evaluated using a step tablet having 21-stages manufactured by Stoffer, Ltd.

### Plating resistance:

Test piece was cross-cut, and immersed at 30°C for 9 minutes in "Autoronex CI" (a gold plating liquid manufactured by Cellrex, Ltd. in USA), followed by performing a peeling test by a cellophane tape.
- ○:: 90/100-100/100
- △:: 50/100-90/100
- X:: 0/100-50/100

### Storage stability: 1 hour:

- ○:: Viscosity increase of less than 10%
- △:: Viscosity increase of 10% to less than 30%
- X:: Viscosity increase of not less than 30%

### Storage stability: Viscosity change at the time lapse of 1 hour and 24 hours

- ○:: Viscosity increase of less than 30%
- △:: Viscosity increase of 30% to less than 50%
- X:: Viscosity increase of not less than 50%

### Developabitily:

- ○:: Conditions that lines are stably remained and paste is not remained between lines.
- △:: Conditions that peeling of lines is less than 10% of the total or undeveloped portions are slightly remained between lines.
- X:: Conditions that peeling of lines is not less than 10% or undeveloped portions are remained (opaque in observation by transmitted light) between lines.

### Line shape after calcination:

- ○:: Conditions that warp and peeling are not observed at cross section of a rib (cell barrier).
- △:: Conditions that warp is slightly observed and peeling is less than 10% at cross section of a rib.
- X:: Conditions that warp is observed and peeling is not less than 10% at cross section of a rib.

Hereinafter, there are illustrated Examples concerning the resin composition of the No. I in the present invention.

### (Synthesis Example I-1)

A 2-liter separable flask equipped with an agitator, a thermometer, a reflux condenser, a dropping funnel, and a tube for supplying nitrogen was charged with 250 g of propylene glycol monomethylether (MMPG manufactured by Daicel Chemical Industries, Ltd.). After temperature was elevated to 110°C, there were simultaneously added dropwise 150 g of acrylic acid, 160 g of methylmethacrylate, 230 g of MMPG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer having carboxylic groups.

Subsequently, 21.0 g of 3,4-epoxycyclohexylmethylacrylate (Cyclomer A200 manufactured by Daicel Chemical Industries, Ltd.), 2.1 g of triphenylphosphine, and 1.0 g of methylhydroquinone were added to the above polymer solution, followed by allowing to react at 100°C for 10 hours. Reaction was carried out under a mixed gas atmosphere composed of air/nitrogen. By the reaction, there was obtained a curable resin solution (AI-1) having an acid value of 100 mgKOH/g, double bond equivalent (resin weight g based on 1 mol of an unsaturated group) of 450, and a weight average molecular weight of 15,000.

### (Synthesis Example I-2)

A 2-liter separable flask equipped with an agitator, a thermometer, a reflux condenser, a dropping funnel, and a tube for supplying nitrogen was charged with 250 g of propylene glycol monomethylether (MMPG manufactured by Daicel Chemical Industries, Ltd.). After temperature was elevated to 110°C, there were simultaneously added dropwise 75 g of acrylic acid, 90 g of methacrylic acid, 145 g of methylmethacrylate, 230 g of MMPG, and 21.7 g of t-butylperoxy-2-ethylhexanoate (Perbutyl O manufactured by Nihon Yushi, Ltd.) over 3 hours.

After dropwise addition, aging was carried out for 3 hours to synthesize a trunk polymer having carboxylic groups. Subsequently, 21.0 g of 3,4-epoxycyclohexyl methylacrylate (Cyclomer A200 manufactured by Daicel Chemical Industries, Ltd.), 2.1 g of triphenylphosphine, and 1.0 g of methylhydroquinone were added to the above solution, followed by allowing to react at 100°C for 10 hours. It is to be noted that reaction was carried out under a mixed gas atmosphere composed of air/nitrogen. By the reaction, there was obtained a curable resin solution (AI-2) having an acid value of 100 mgKOH/g, double bond equivalent (resin weight g based on 1 mol of an unsaturated group) of 450, and a weight average molecular weight of 15,500.

### (Synthesis Example I-3)

A 2-liter separable flask equipped with an agitator, a thermometer, a reflux condenser, a dropwise funnel, and a tube for supplying nitrogen was charged with 250 g of propylene glycol monomethylether (MMPG manufactured by Daicel Chemical Industries, Ltd.). After temperature was elevated to 110°C, there were simultaneously added dropwise 179 g of methacrylic acid, 131 g of methylmethacrylate, 230 g of MMPG, and 21.7 g of t-butylperoxy-2-ethylhexanoate (Perbutyl O manufactured by Nihon Yushi, Ltd.) over 3 hours.

After dropwise addition, aging was carried out for 3 hours to synthesize a trunk polymer having carboxylic groups. Subsequently, 21.0 g of 3,4-epoxycyclohexyl methylacrylate (Cyclomer A200 manufactured by Daicel Chemical Industries, Ltd.), 2.1 g of triphenylphosphine, and 1.0 g of methylhydroquinone were added to the above solution, followed by allowing to react at 100°C for 10 hours. It is to be noted that reaction was carried out under a mixed gas atmosphere composed of air/nitrogen.

By the reaction, there was obtained a curable resin solution (AI-3) having an acid value of 100 mgKOH/g, double bond equivalent (resin weight g based on 1 mol of an unsaturated group) of 450, and a weight average molecular weight of 16,500.

### (Examples I-1 and I-2, Comparative Example I-1)

There were mixed respective 100 parts by weight (solid components) of the curable resin solutions AI-1 to AI-3 (AI-1 and AI-2 were employed in Examples and AI-3 was employed in Comparative Example), 20 parts by weight of trimethylol propane triacrylate, 20 parts by weight of a cresol novolak type epoxy resin having an epoxy equivalent of 220 (Epikote 180S70 manufactured by Yuka Shell Epoxy, Ltd.), 7 parts by weight of benzyl methyl ketal, 2 parts by weight of diethyl thioxanthone, 1.5 part by weight of Phthalocyanine Green, 5 parts by weight of silica, 20 parts by weight of barium sulphate, and 5 parts by weight of dicyandiamide, followed by kneading by a three-rolls machine to obtain a viscous ink composition.

The ink composition obtained in the above-described step was coated in the thickness of 20 µm using a bar coater on a base plate having a pattern, followed by drying at 80°C using an air-blowing dryer for 20 minutes. After that, a negative film was in contact with the base plate, and radiation dose of 800 mJ/cm² was irradiated. Further, it was developed using 1% sodium carbonate solution, and a coating layer obtained was cured at 150°C for 30 minutes in an air-circulating oven.

Sensitivity was evaluated using a step tablet having 21-stages by Stoffer, and it is shown in Table I-1.

**Table I-1**

| | Resin solution employed | Sensitivity |
|---|---|---|
| Example I-1 | AI-1 | 11 |
| Example I-2 | AI-2 | 10 |
| Comparative ExampleI-1 | AI-3 | 8 |

As being distinct from results, it was confirmed that the inks in the Examples are excellent in 2-3 stages of sensitivity compared to that in the Comparative Example. In detail, it was confirmed that sensitivity of the inks is remarkably improved by the use of resin composition in which the presence of acrylic acid in a modified copolymer is an essential requirement.

Hereinafter, the No. II of the present invention is specifically illustrated by Examples.

### (Synthesis Example II-1)

A 2-liter separable flask equipped with an agitator, a thermometer, a reflux condenser, a dropping funnel, and a tube for supplying nitrogen was charged with 325 g of dipropylene glycol monomethylether (MFDG manufactured by Nihon Nyukazai, Ltd.). After temperature was elevated to 110°C, there were simultaneously added dropwise 37.6 g of βCEA (β-carboxyethylacrylate), 201.9 g of methacrylic acid, 186.4 g of methylmethacrylate, 222 g of MFDG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (corresponding to the copolymer (BII)) having a Tg of 137°C.

Subsequently, 289.2 g of 3,4-epoxycyclohexyl methylacrylate (Cyclomer A200 manufactured by Daicel Chemical Industries, Ltd.), 2.9 g of triphenylphosphine, and 1.3 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AII-1) having an acid value of 100 mgKOH/g, double bond equivalent (resin weight g based on 1 mol of an unsaturated group) of 450, and a weight average molecular weight of 15,000.

### (Synthesis Example II-2)

A 2-liter separable flask equipped with an agitator, a thermometer, a reflux condenser, a dropping funnel, and a tube for supplying nitrogen was charged with 325 g of dipropylene glycol monomethylether (MFDG manufactured by Nihon Nyukazai, Ltd.). After temperature was elevated to 110°C, there were simultaneously added dropwise 187.8 g of βCEA (β-carboxyethylacrylate), 112.2 g of methacrylic acid, 125.9 g of methylmethacrylate, 222 g of MFDG, and 17.0 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (corresponding to the copolymer (BII)) having a Tg of 62°C.

Subsequently, 289.2 g of 3,4-epoxycyclohexyl methylacrylate (Cyclomer A200 manufactured by Daicel Chemical Industries, Ltd.), 2.9 g of triphenylphosphine, and 1.3 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AII-2) having an acid value of 100 mgKOH/g, double bond equivalent (resin weight g based on 1 mol of an unsaturated group) of 450, and a weight average molecular weight of 20,000.

### (Synthesis Example II-3)

A 2-liter separable flask equipped with an agitator, a thermometer, a reflux condenser, a dropping funnel, and a tube for supplying nitrogen was charged with 250 g of propylene glycol monomethylether (MMPG manufactured by Daicel Chemical Industries, Ltd.). After temperature was elevated to 110°C, there were simultaneously added dropwise 187.8 g of βCEA (β-carboxyethylacrylate), 112.2 g of methacrylic acid, 125.9 g of adamantyl acrylate, 222 g of MFDG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (corresponding to the copolymer (BII)) having a Tg of 78°C. Subsequently, 289.2 g of 3,4-epoxycyclohexyl methylacrylate (Cyclomer A200 manufactured by Daicel Chemical Industries, Ltd.), 2.9 g of triphenylphosphine, and 1.3 g of methylhydroquinone were added to the trunk polymer solution, followed by allowing to react at 100°C for 10 hours.

Reaction was carried out under a mixed gas atmosphere composed of air/nitrogen. By the reaction, there was obtained a curable resin solution (AII-3) having an acid value of 100 mgKOH/g, double bond equivalent (resin weight g based on 1 mol of an unsaturated group) of 450, and a weight average molecular weight of 14,000.

### (Synthesis Example II-4)

A 2-liter separable flask equipped with an agitator, a thermometer, a reflux condenser, a dropwise funnel, and a tube for supplying nitrogen was charged with 325 g of dipropylene glycol monomethylether (MFDG manufactured by Nihon Nyukazai, Ltd.). After temperature was elevated to 110°C, there were simultaneously added dropwise 375.7 g of βCEA (β-carboxyethylacrylate), 50.2 g of methylmethacrylate, 222 g of MFDG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (corresponding to the copolymer (BII) not having a (meth)acrylic acid structural unit) having a Tg of 0°C. Subsequently, 289.2 g of 3,4-epoxycyclohexyl methylacrylate (Cyclomer A200 manufactured by Daicel Chemical Industries, Ltd.), 2.9 g of triphenylphosphine, and 1.3 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AII-4) having an acid value of 100 mgKOH/g, double bond equivalent (resin weight g based on 1 mol of an unsaturated group) of 450, and a weight average molecular weight of 15,000.

### (Synthesis Example II-5)

A 2-liter separable flask equipped with an agitator, a thermometer, a reflux condenser, a dropping funnel, and a tube for supplying nitrogen was charged with 1090 g of a cresol novolak type epoxy resin having an epoxy equivalent of 215 (YDCN-702 manufactured by Toto Kasei, Ltd.), followed by melting by heating at 110°C. subsequently, there were added 390 g of acrylic acid, 1.5 g of methylhydroquinone, and 2 g of dimethyl benzyl amine, followed by allowing to react at 110°C for 12 hours. By the reaction, there was synthesized an acrylic acid-modified product of the novolak type epoxy resin having an acid value of 3.0 mgKOH/g. 250 g of ethylcarbitol acetate was added to 450 g of the product. After heating to 80°C, there was obtained a curable resin solution (AII-5) having unsaturated groups and acid groups in which an acid anhydride is added after modification of an epoxy resin having an acid value of 58 mgKOH/g by acrylic acid through allowing to react 0.5 mol of tetrahydrophthalic anhydride based on 1 hydroxyl group equivalent.

### (Examples II-1 to II-5, Comparative Examples II-1 and II-2)

Using the resin solutions AII-1 to AII-5 obtained in the Synthesis Examples at formulating proportion (solid components) shown in Table II-1, there were mixed 20 parts by weight of trimethylol propane triacrylate, 20 parts by weight of a cresol novolak type epoxy resin having an epoxy equivalent of 220 (Epikote 180S70 manufactured by Yuka Shell Epoxy, Ltd.), 7 parts by weight of benzyl methyl ketal as a photopolymerization initiator, 2 parts by weight of diethyl thioxanthone as a photopolymerization initiator, 1.5 part by weight of Phthalocyanine Green, 5 parts by weight of silica, 20 parts by weight of barium sulphate, and 5 parts by weight of dicyandiamide, followed by kneading by a three-rolls machine to obtain a viscous ink composition. The ink composition obtained was coated in the thickness of 20 µm using a bar coater on a base plate having a pattern, followed by drying at 80°C using an air-blowing dryer for 20 minutes. After that, a negative film was in contact with the base plate, and radiation dose of 800 mJ/cm² was irradiated. Further, it was developed using 1% sodium carbonate aqueous solution, and a coating layer obtained was cured at 150°C for 30 minutes in an air-circulating oven to obtain a cured coating layer.

Finger touch dryability and sensitivity were evaluated concerning the cured coating layer, and results are shown in Table II-1.

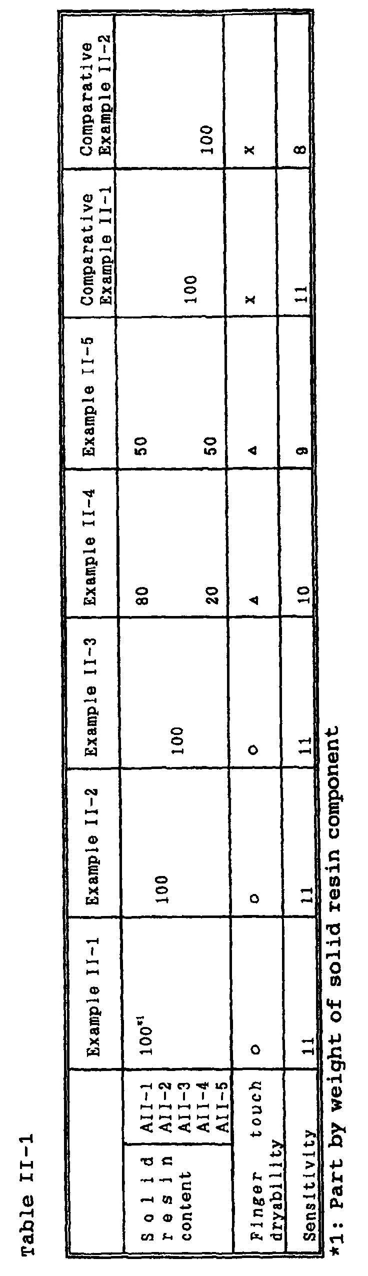

As being distinct from the Examples, there can be obtained a curable resin for an ink material having a high sensitivity and an excellent tackfree property, or a photocurable resin composition according to the No. II of the present invention.

Hereinafter, the No. III of the present invention is specifically illustrated Examples.

A 2-liter separable flask equipped with an agitator, a thermometer, a reflux condenser, a dropping funnel, and a tube for supplying nitrogen was employed as a reaction vessel.
Solvent: dipropylene glycol monomethylether (MFDG manufactured by Nihon Nyukazai, Ltd.) and propylene glycol monomethylether (MMPG manufactured by Daicel Chemical Industries, Ltd.)
Polymerization initiator: t-butylperoxy-2-ethylhexanoate (Perbutyl O manufactured by Nihon Yushi, Ltd.)
Unsaturated compound having epoxy group (dIII): 3,4-epoxycyclohexyl methylacrylate (Cyclomer A200 manufactured by Daicel Chemical Industries, Ltd.)
Acetoacetoxyethyl acrylate: AAEM
Acryloyl morpholine: ACMO
Tetrahydrofurfuryl acrylate: THFA
Double bond equivalent: resin weight (g) based on 1 mol of an unsaturated group

### (Synthesis of a modified copolymer III-1)

A separable flask was charged with 325 g of MFDG and, after elevating to temperature of 110°C, there were simultaneously added dropwise 37.6 g of βCEA, 201.9 g of methacrylic acid, 186.4 g of methylmethacrylate, 222 g of MPDG, and 12.0 g of t-butylperoxy-2-ethylhexanoate over 3 hours. After dropwise addition, aging was carried out for 3 hours to synthesize a trunk polymer solution having carboxylic groups.

Subsequently, 289.2 g of 3,4-epoxycyclohexyl methylacrylate, 2.9 g of triphenylphosphine, and 1.3 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AIII-1) having an acid value of 100 mgKOH/g, double bond equivalent of 450, and a weight average molecular weight of 15,000.

### (Example III-1)

As shown in Table III-1, 5 parts by weight of acetoacetoxy ethyl acrylate was added to 100 parts by weight of the curable resin solution (AIII-1) to obtain a resin composition of the present invention.

In order to examine properties of the resin composition of the present invention, the following tests were conducted. Results are shown in Table III-1.

There were mixed 100 parts by weight (as solid components) of the resin composition obtained in the Example III-1, 20 parts by weight of trimethylol propane triacrylate, 20 parts by weight of a cresol novolak type epoxy resin having an epoxy equivalent of 220 (Epikote 180S70 manufactured by Yuka Shell Epoxy, Ltd.), 7 parts by weight of benzyl methyl ketal, 2 parts by weight of diethyl thioxanthone, 1.5 part by weight of Phthalocyanine Green, 5 parts by weight of silica, 20 parts by weight of barium sulphate, and 5 parts by weight of dicyandiamide, followed by kneading by a three-rolls machine to obtain a viscous composition.

The composition obtained above was coated in the thickness of 20 µm using a bar coater on a base plate having a pattern, followed by drying at 80°C using an air-blowing dryer for 20 minutes. After that, a negative film was in contact with the base plate, and radiation dose of 800 mJ/cm² was irradiated. Further, it was developed using 1% sodium carbonate aqueous solution, and a coating layer was cured at 150°C for 30 minutes in an air-circulating oven.

### (Examples III-2 and III-3)

As shown in Table III-1, 5 parts by weight of acryloyl morpholine (Example III-2) and 5 parts by weight of tetrahydrofurfuryl acrylate (Example III-3) were added to 100 parts by weight of the curable resin solution (AIII-1), respectively, to obtain a resin composition of the present invention.

In order to examine properties of the resin composition of the present invention, the same tests were performed as in the Examples III-1 using the resin composition obtained in the Example III-2 or Example III-3 in place of the resin composition obtained in the Example III-1. Results are shown in Table III-1.

### (Comparative Example III-1)

In order to examine properties of the curable resin solution (AIII-1) alone, the same test was performed as in the Examples III-1 using the curable resin solution (AIII-1) alone in place of the resin composition obtained in the Example III-1. Results are shown in Table III-1.

### (Example III-4) (synthesis of a modified copolymer III-2)

A separable flask was charged with 250 g of MFDG and, after elevating to temperature of 110°C, there were simultaneously added dropwise 26.3 g of βCEA, 141.2 g of methacrylic acid, 34.8 g of methylmethacrylate, 95.5 g of acetoacetoxyethyl methacrylate, 223 g of MFDG, and 12.0 g of t-butylperoxy-2-ethylhexanoate over 3 hours. After dropwise addition, aging was carried out for 3 hours to synthesize a trunk polymer solution having carboxylic groups.

Subsequently, 202.2 g of 3,4-epoxycyclohexyl methylacrylate, 2.0 g of triphenylphosphine, and 1.0 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AIII-2) of the present invention having an acid value of 100 mgKOH/g, double bond equivalent of 450, and a weight average molecular weight of 15,000.

In order to examine properties of the modified copolymer of the present invention, the same test was performed as in the Examples III-1 using the resin composition obtained in the Example III-4 in place of the resin composition obtained in the Example III-1. Results are shown in Table III-1.

### (Example III-5) (Synthesis of a modified copolymer III-3)

A separable flask was charged with 250 g of MFDG and, after elevating to temperature of 110°C, there were added dropwise 26.3 g of βCEA, 141.2 g of methacrylic acid, 59.8 g of methylmethacrylate, 70.5 g of acryloyl morpholine, 223 g of MFDG, and 12.0 g of t-butylperoxy-2-ethylhexanoate over 3 hours. After dropwise addition, aging was carried out for 3 hours to synthesize a trunk polymer solution having carboxylic groups.

Subsequently, 202.2 g of 3,4-epoxycyclohexyl methylacrylate, 2.0 g of triphenylphosphine, and 1.0 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AIII-3) having an acid value of 100 mgKOH/g, double bond equivalent of 450, and a weight average molecular weight of 14,000.

In order to examine properties of the modified copolymer of the present invention, the same test was performed as in the Examples III-1 using the resin composition obtained in the Example III-5 in place of the resin composition obtained in the Example III-1. Results are shown in Table III-1.

### (Example III-6) (Synthesis of a modified copolymer III-4)

A separable flask was charged with 250 g of MFDG and, after elevating to temperature of 110°C, there were simultaneously added dropwise 26.3 g of βCEA, 141.2 g of methacrylic acid, 91.3 g of methylmethacrylate, 39.0 g of tetrahydrofurfuryl acrylate, 223 g of MFDG, and 12.0 g of t-butylperoxy-2-ethylhexanoate over 3 hours.

After dropwise addition, aging was carried out for 3 hours to synthesize a trunk polymer solution having carboxylic groups.

Subsequently, 202.2 g of 3,4-epoxycyclohexyl methylacrylate, 2.0 g of triphenylphosphine, and 1.0 g of methylhydroquinone were added to the trunk polymer solution, followed by allowing to react at 100°C for 10 hours. Reaction was carried out under a mixed gas atmosphere composed of air/nitrogen. By the reaction, there was obtained a curable resin solution (AIII-4) having an acid value of 100 mgKOH/g, double bond equivalent of 450, and a weight average molecular weight of 13,500.

In order to examine properties of the modified copolymer of the present invention, the same test was performed as in the Examples III-1 using the resin composition obtained in the Example III-6 in place of the resin composition obtained in the Example III-1. Results are shown in Table III-1.

### (Synthesis of a modified copolymer III-5)

A separable flask was charged with 1090 g of a cresol novolak type epoxy resin having an epoxy equivalent of 215 (YDCN-702 manufactured by Toto Kasei, Ltd.), followed by melting through heating at 100°C. Subsequently, there were added 390 g of acrylic acid, 1.5 g of methylhydroquinone, and 2 g of dimethylbenzyl amine, followed by allowing to react at 110°C for 12 hours. By the reaction, there was synthesized an acrylic acid-modified product having an acid value of 3.0 mgKOH/g of the novolak type epoxy resin.

250 g of ethylcarbitol acetate was added to 450 g of the product and, after heating to 80°C, there was obtained a curable resin solution (AIII-5) having unsaturated groups and acid groups in which an acid anhydride is added after modification by allowing to react 0.5 mol of tetrahydrophthalic anhydride based on 1 acid group equivalent, and which has an acid value of 58 mgKOH/g.

### (Comparative Example III-2)

In order to examine properties of the modified copolymer III-5, the same test was performed as in the Example III-1 using the modified copolymer III-5 alone in place of the resin composition obtained in the Example III-1. Results are shown in Table III-1.

### (Example III-7)

The same test was performed as in the Example III-1 using the modified copolymer III-1 and the modified copolymer III-5 as shown in Table III-1 in place of the resin composition obtained in the Example III-1. Results are shown in Table III-1.

**Table III-1**

| | Example III- | | | | | | | Comparative Example III- | |
|---|---|---|---|---|---|---|---|---|---|
| | 1 | 2 | 3 | 4 | 5 | 6 | 7 | 1 | 2 |
| Resin solution | | | | | | | | | |
| AIII-1 | 100 | 100 | 100 | | | | 50 | 100 | |
| AIII-2 | | | | 100 | | | | | |
| AIII-3 | | | | | 100 | | | | |
| AIII-4 | | | | | | 100 | 50 | | |
| AIII-5 | | | | | | | | | 100 |

| Monomer | | | | | | | | | |
|---|---|---|---|---|---|---|---|---|---|
| AAEM | 5 | | | | | | 5 | | |
| ACMO | | 5 | | | | | | | |
| THFA | | | 5 | | | | | | |
| Finger touch dryability | △ | △ | △ | ○ | ○ | ○ | △ | ○ | X |
| Sensitivity | 11 | 11 | 11 | 10 | 10 | 10 | 10 | 10 | 8 |
| Plating resistance | ○ | ○ | ○ | ○ | ○ | ○ | ○ | △ | ○ |

| | | | | | | | | | |
|---|---|---|---|---|---|---|---|---|---|
| Note) Resin solution: part by weight of solid resin component | | | | | | | | | |
| Monomer: part by weight | | | | | | | | | |

As being distinct from the above-described results, resists using the compositions in the Examples are excellent at 2-3 stages and, also in finger touch dryability and, sensitivity is jumpingly improved, and further, plating resistance is improved compared to resists prepared from compositions in the Comparative Example.

Hereinafter, the No. IV of the present invention is specifically illustrated by Examples.

### (Synthesis Example IV-1)

A 2-liter separable flask equipped with an agitator, a thermometer, a reflux condenser, a dropping funnel, and a tube for supplying nitrogen was charged with 250 g of dipropylene glycol monomethylether (MFDG manufactured by Nihon Nyukazai, Ltd.). After temperature was elevated to 110°C, there were simultaneously added dropwise 150 g of acrylic acid (bIV-1), 160 g of methylmethacrylate (aIV-1), 230 g of MFDG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (hereinafter, it means a copolymer) (cIV-1) having carboxylic groups. Reaction was performed under a nitrogen atmosphere.

Subsequently, 210 g of 3,4-epoxycyclohexylmethylacrylate (dIV-1) (Cyclomer A200 manufactured by Daicel Chemical Industries, Ltd.), 2.1 g of triphenylphosphine, and 1.0 g of methylhydroquinone were added to the trunk polymer solution (cIV-1), followed by allowing to react at 100°C for 10 hours. Reaction was carried out under a mixed gas atmosphere composed of air/nitrogen.

By the reaction, there was obtained a curable resin solution (AIV-1) having an acid value of 100 mgKOH/g, double bond equivalent of 450, and a weight average molecular weight of 15,000. It is to be noted that dipropylene glycol monomethylether functions as a solvent for dilution (DIV-1).

### (Synthesis Example IV-2)

The same reaction vessel as in the Synthesis Example IV-1 was charged with 250 g of dipropylene glycol monomethylether (MFDG manufactured by Nihon Nyukazai, Ltd.). After temperature was elevated to 110°C, there were simultaneously added dropwise 75 g of acrylic acid (bIV-1), 90 g of methacrylic acid (bIV-2), 145 g of methylmethacrylate (aIV-1), 230 g of MFDG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (cIV-2) having carboxylic groups.

Subsequently, 210 g of 3,4-epoxycyclohexylmethylacrylate (dIV-1) (Cyclomer A200 manufactured by Daicel Chemical Industries, Ltd.), 2.1 g of triphenylphosphine, and 1.0 g of methylhydroquinone were added to the trunk polymer solution (cIV-2), followed by allowing to react at 100°C for 10 hours.

Reaction was carried out under a mixed gas atmosphere composed of air/nitrogen.

By the reaction, there was obtained a curable resin solution (AIV-2) having an acid value of 100 mgKOH/g, double bond equivalent of 450, and a weight average molecular weight of 15,500.

### (Synthesis Example IV-3)

The same reaction vessel as in the Synthesis Example IV-1 was charged with 250 g of dipropylene glycol monomethylether (MFDG manufactured by Nihon Nyukazai, Ltd.). After temperature was elevated to 110°C, there were simultaneously added dropwise 179 g of methacrylic acid (bIV-1), 131 g of methylmethacrylate (aIV-1), 230 g of MFDG, and 21.7 g of t-butylperoxy-2-ethylhexanoate (Perbutyl O manufactured by Nihon Yushi, Ltd.) over 3 hours.

After dropwise addition, aging was further carried out for 3 hours to synthesize a trunk polymer (cIV-3) having carboxylic groups.

Subsequently, 210 g of 3,4-epoxycyclohexylmethylacrylate (dIV-1) (Cyclomer A200 manufactured by Daicel Chemical Industries, Ltd.), 2.1 g of triphenylphosphine, and 1.0 g of methylhydroquinone were added to the trunk polymer solution (cIV-3), followed by allowing to react at 100°C for 10 hours. Reaction was carried out under a mixed gas atmosphere composed of air/nitrogen.

By the reaction, there was obtained a curable resin solution (AIV-3) having an acid value of 100 mgKOH/g, double bond equivalent of 450, and a weight average molecular weight of 16,500.

### (Comparative Synthesis Example IV-1)

The same reaction vessel as in the Synthesis Example IV-1 was charged with 250 g of dipropylene glycol monomethylether (MFDG manufactured by Nihon Nyukazai, Ltd.). After temperature was elevated to 110°C, there were simultaneously added dropwise 179 g of methacrylic acid (bIV-1), 177 g of methylmethacrylate (aIV-1), 230 g of MFDG, and 21.7 g of t-butylperoxy-2-ethylhexanoate (Perbutyl O manufactured by Nihon Yushi, Ltd.) over 3 hours. After dropwise addition, aging was carried out for 3 hours to synthesize a trunk polymer (cIV-4) having carboxylic groups.

Subsequently, 164 g of glycidyl methacrylate (Blemmer G manufactured by Nihon Yushi, Ltd.), 1.7 g of triphenylphosphine, and 1.0 g of methylhydroquinone were added to the trunk polymer solution (cIV-4), followed by allowing to react at 100°C for 10 hours. Reaction was carried out under a mixed gas atmosphere composed of air/nitrogen.

By the reaction, there was obtained a curable resin solution (AIV-4) having an acid value of 100 mgKOH/g, double bond equivalent of 450, and a weight average molecular weight of 16,500.

### (Examples IV-1 to IV-3 and Comparative Example IV-1)

Using the copolymerized resin solutions (AIV) obtained in the above-described Synthesis Examples IV-1 to IV-3 and Comparative Synthesis Example IV-1, the components (BIV) to (HIV) were mixed in the composition ratio shown in Table IV-1, and agitated by an agitator, followed by kneading with a three-rolls machine to conduct pasting.

In the case, there was employed a glass frit (EIV) having PbO of 60%, B₂O₃ of 20%, SiO₂ of 15%, and Al₂O₃ of 5% (composition ratio), an average particle diameter of 2.5 µm, volume expansion coefficient α (300°c) of 70x10⁻⁷/°C, and a glass transition temperature of 445°C. Further, as black-colored pigment, there was employed an oxide of Cu, Cr, and Mn having an average particle diameter of 1 µm.

Using alkali-developable type photocurable glass paste compositions obtained above, storage stability (viscosity stability) was evaluated by measuring a viscosity after 1 hour and 24 hours.

Further, using alkali-developable type photocurable glass paste compositions obtained above, cell barriers for a plasma display panel were formed on a glass base plate, and there were evaluated tackiness after drying (a finger touching test), sensitivity (visual observation of the base plate after development and visual observation by transmitted light from back surface of the base plate after development), and line shape of the cell barriers after calcination.

Formation of the cell barriers was conducted by the following steps. First of all, a composition at time lapse of 1 hour after preparation was coated on all surface of a glass base plate using a polyester screen having 300 meshes, and dried at 90°C for 20 minutes using a heated air-circulating furnace to form a thin layer (a coating layer).

Subsequently, exposure to light was conducted using a metal halide lamp as a light source through a negative film having a lattice-shaped pattern forming line width of 50 µm, so that totalized quantity of light becomes 200 mJ/cm² on the composition.

After that, it was developed using an aqueous solution of 1 wt%-Na₂CO₃ at liquid temperature of 30°C and washed by water.

Finally, temperature was further elevated after maintaining at 450°C for 30 minutes in air, followed by calcining at 530°C for 30 minutes to prepare a base plate having cell barriers. Table IV-1 shows results of tests concerning the base plate obtained.

**Table IV-1**

| | | Composition | | | |
|---|---|---|---|---|---|
| | | Example IV- | | | Comparative Example IV- |
| | | 1 | 2 | 3 | 1 |
| Resin (AIV) | | (AIV-1) 100 | (AIV-2) 100 | (AIV-3) 100 | (AIV-4) 100 |
| Photopolymerizable monomer^{*1} (CIV-1) | | 50 | 50 | 50 | 50 |
| Photopolymerization initiator^{*2} (BIV-1) | | 10 | 10 | 10 | 10 |
| Solvent for dilution^{*3} (DIV-1) | | 100 | 100 | 100 | 100 |
| Black-colored pigment (HIV-1) | | 30 | 30 | 30 | 30 |
| Glass frit (EIV-1) | | 450 | 450 | 450 | 450 |
| Oxide of phosphorus^{*4} (FIV-1) | | 6 | 6 | 6 | 6 |
| Ceramic powder^{*5} (GIV-1) | | 250 | 250 | 250 | 250 |

| Evalution result | | | | | |
|---|---|---|---|---|---|
| Finger touch dryability | | ○ | ○ | ○ | X |
| Sensitivity | | 7 | 7 | 6 | 4 |
| Storage stability | (1 hr) | ○ | ○ | ○ | ○ |
| | (24hr) | ○ | ○ | ○ | ○ |
| Developability | | ○ | ○ | △ | △ |
| Line shape after calcination | | ○ | ○ | ○ | △ |

| | | | | | |
|---|---|---|---|---|---|
| Note *1 Pentaerythritol triacrylate | | | | | |
| *2 2-benzyl-2-dimethylamino-1-(4-morpholinophenyl)-butane-1-on | | | | | |
| *3 Dipropylene glycol monmethylether | | | | | |
| *4 Phosphorus acid | | | | | |
| *5 Alumina | | | | | |

As in the present invention, the use of the copolymer resin elevates a glass transition point in the resin after curing, in which the cycloaliphatic epoxy group-contained unsaturated compound (dIV) is added, whereby, there are obtained cell barriers having a high precision. On the other hand, the use of the copolymer resin provides an insufficient resolution, in which there is added the aliphatic epoxy group-contained unsaturated compound (d'IV) such as glycidyl methacrylate alone.

### Possibility of utilization in Industry

The use of the curable resin composition of the No. I in the present invention provides a remarkably improved sensitivity in an ink, in which the presence of acrylic acid is an essential requirement in the modified copolymer resin.

According to the No. II in the present invention, there can be provided the curable resin and/or the photocurable resin composition for ink materials having a high sensitivity and excellent tackfree property.

According to the No. III in the present invention, there can be provided the curable resin or the photocurable resin composition which can be developed by an alkali and satisfies various properties to be required in a solder resist in the case of using for the solder resist, and which has a high sensitivity, a high resolution, an improved plating resistance, and an excellent finger touch dryability.

According to the No. IV in the present invention, there can be formed a fine-grained cell barrier pattern on a base plate for a large-sized plasma display panel without a problem such as a change for the worse in working circumstances, and with a high yield and stable and excellent productivity by a photolithography technology.

Accordingly, the curable resin, the curable resin composition, and a modified copolymer and/or the resin composition (I) in the present invention are useful in various coating fields such as general-purpose inks, plastic coatings, paper materials for printing, coating materials for films, and coatings for furniture, FRP, linings, further, varnishes for insulation, insulation sheets, laminated boards, print circuit boards, LSI materials, prism sheets, resist inks, liquid resists, dry films, color filters to be employed for a liquid crystal, pigment resists for black matrix, additives for a protection layer in coatings, pigment resist inks for a color filter, encapsulants for semiconductors, and base plates for a plasma display panel, etc. in electronics fields, and those can be utilized in wide industrial fields.

## Claims

1. A curable resin composition characterized by using a modified copolymer in which an epoxy group-contained unsaturated compound is added to a portion of acid groups in a copolymer containing acrylic acid and a (meth)acrylate as a main comonomer component.

2. A curable resin composition as claimed in claim 1, wherein there is employed a compound except acrylic acid having an unsaturated group and at least one acid group in place of a portion of the acrylic acid.

3. A curable resin composition as claimed in claim 1 or 2, wherein said epoxy group-contained unsaturated compound is a cycloaliphatic epoxy group-contained unsaturated compound.

4. A curable resin composition as claimed in claim 3, wherein said cycloaliphatic epoxy group-contained unsaturated compound is 3,4-epoxycyclohexylmethyl(meth)acrylate.

5. A curable resin composition as claimed in any one of claims 1-4, wherein said curable resin composition contains a photo-polymerization initiator and a monomer or oligomer for dilution.

6. A curable resin composition as claimed in any one of claims 1-5, wherein an epoxy compound and/or an epoxy resin are contained.

7. A curable resin composition as claimed in any one of claims 1-6, wherein pigments are contained.

8. A curable resin composition as claimed in any one of claims 1-7, which is employed as photocurable components for a liquid resist, a dry film, and a pigment resist in a color filter.

9. A curable resin composition as claimed in any one of claims 1-7, which is employed as heat-curable components for a liquid resist, a dry film, and a pigment resist for a color filter.

10. A curable resin comprising a modified copolymer obtained by addition of an epoxy group-contained unsaturated compound (CII) to a portion of acid groups in a copolymer (BII) having a Tg (a glass transition temperature) of not less than 50°C obtained from a compound (AII) having a divalent group which can be bonded between an unsaturated group and carboxylic group, a (meth)acrylic acid or a (meth)acrylate.

11. A curable resin as claimed in claim 10, wherein said compound (AII) having a divalent group which can be bonded between an unsaturated group and carboxylic group is β-carboxyethyl (meth)acrylate.

12. A curable resin as claimed in claim 10 or 11, wherein said epoxy group-contained unsaturated compound (CII) is 3,4-epoxycyclohexylmethyl(meth)acrylate.

13. A curable resin composition which is soluble to a diluted aqueous alkali solution, and which comprises said curable resin as claimed in claim 12 and a monomer or oligomer for dilution.

14. A curable resin composition which is soluble to a diluted aqueous alkali solution, and which comprises the curable resin as claimed in claim 12, a photo-polymerization initiator, and a monomer or oligomer for dilution.

15. A curable resin composition in which the curable resin composition as claimed in claim 13 or 14 further contains an epoxy compound and/or an epoxy resin.

16. A curable resin composition as claimed in any one of claims 13-15 which further contains pigments.

17. A curable resin composition as claimed in any one of claims 13-16 which contains a resin in which an acid anhydride is added after modifying a novolak or bisphenol-based epoxy resin with a (meth)acrylic acid.

18. A curable resin composition as claimed in any one of claims 13 or 14 which is employed as a liquid resist, a dry film, a color filter for a liquid crystal display, a pigment resist for black matrix, and a protecting layer for a coating.

19. A resin composition comprising mixing at least one acrylate monomer (eIII) having functional groups selected from acetoacetoxyethyl acrylate, acryloyl morpholine, and tetrahydrofurfuryl acrylate with a modified copolymer (BIII) obtained by addition of an epoxy group in an epoxy group-contained unsaturated compound (dIII) to a portion of acid groups in a copolymer (PIII-2) composed of β-carboxyethyl(meth)acrylate (aIII), an unsaturated compound having an acid group (bIII), and a (meth)acrylate (cIII).

20. A modified copolymer obtained by addition of an epoxy group in an epoxy group-contained unsaturated compound (dIII) to a portion of acid groups in a copolymer (PIII-1) composed of β-carboxyethyl(meth)acrylate (aIII), an unsaturated compound (bIII) having an acid group, and a (meth)acrylate (cIII), at least one of an acrylate monomer (eIII) having functional groups selected from acetoacetoxyethyl acrylate, acryloyl morpholine, and tetrahydrofurfuryl acrylate.

21. A resin composition as claimed in claim 19, characterized in that said epoxy group-contained unsaturated compound (dIII) is 3,4-epoxycyclohexylmethyl (meth)acrylate.

22. A modified copolymer as claimed in claim 20, characterized in that the epoxy group-contained unsaturated compound (dIII) is 3,4-epoxycyclohexylmethyl (meth)acrylate.

23. A resin composition which comprises a resin composition as claimed in claim 19 and/or a modified copolymer as claimed in claim 20 and other epoxy compounds (DIII).

24. A resin composition which comprises the resin composition as claimed in claim 19 or 23 or the modified copolymer as claimed in claim 20 and other compounds (EIII) having an unsaturated group and an acid group obtained by addition of an acid anhydride after modifying a novolak-based epoxy resin and/or a bisphenol-based epoxy resin by a (meth)acrylic acid.

25. An alkali-developable type photo-curable glass paste composition characterized by containing the following (AIV), (BIV), (CIV), (DIV), and (EIV),
(AIV): a copolymeric resin in which an unsaturated compound (dIV) having an cycloaliphatic epoxy group is allowed to add to a portion of acid groups in a copolymer (cIV) obtained from a (meth)acrylate (aIV) and a compound (bIV) having an unsaturated group and at least one acid groups under the presence of catalysts,
(BIV): a photopolymerization initiator,
(CIV): a photopolymerizable monomer,
(DIV): a solvent for dilution,
(EIV): glass frit.

26. An alkali-developable type photo-curable glass paste composition as claimed in claim 25, characterized by further containing a phosphoric acid compound (FIV) and ceramic powder (GIV).

27. An alkali-developable type photo-curable glass paste composition as claimed in claim 25 or 26, characterized by further containing a black-colored pigment (HIV).

28. An alkali-developable type photo-curable glass paste composition as claimed in claim 25, characterized in that a weight average molecular weight is 5,000-50,000, an acid value is 50-150 KOH mg/g, and a double bond equivalent is 400-2,000 in said copolymeric resin (AIV).

29. An alkali-developable type photo-curable glass paste composition as claimed in claim 28, characterized by using a mixture of a copolymeric resin (AIV) having an acid value of not less than 100 KOH mg/g with a copolymeric resin (AIV) having an acid value of less than 100 KOH mg/g.

30. An alkali-developable type photo-curable glass paste composition as claimed in claim 25, wherein a glass transition point in said glass frit (EIV) is 300-550°C.

31. An alkali-developable type photo-curable glass paste composition as claimed in claim 27, in which the black-colored pigment (HIV) is a metal oxide pigment primarily containing at least one or more kinds of an oxide of Fe, Cr, Mn, and Co, and which contains 3-100 parts by weight of the metal oxide pigment based on 100 parts by weight of the glass frit (EIV).

32. A method for the preparation of cell barriers in a plasma display panel characterized by including a step in which an alkali-developable type photo-curable glass paste composition as claimed in any one of claims 25-31 is coated onto a glass base plate for a plasma display panel to prepare a coating layer, a step in which said coating layer is selectively exposed to an active beam depending upon a fixed pattern, a step in which unexposed portions in said coating layer is removed by developing using an aqueous alkali solution, and a step in which said coating layer is calcined after developing.
